# EUROPÄISCHE PATENTSCHRIFT

(11) **EP 3 391 424 B1**
(45) Veröffentlichungstag und Bekanntmachung des Hinweises auf die Patenterteilung: **07.09.2022**
(21) Anmeldenummer: 16819479.3
(22) Anmeldetag: 13.12.2016
(51) Int. Cl.: H01L 33/50, F21K 9/64

(54) **KONVERTER ZUR ERZEUGUNG EINES SEKUNDÄRLICHTS AUS EINEM PRIMÄRLICHT, LEUCHTMITTEL, DIE SOLCHE KONVERTER ENTHALTEN, SOWIE VERFAHREN ZUR HERSTELLUNG DER KONVERTER**
CONVERTER FOR GENERATING A SECONDARY LIGHT FROM A PRIMARY LIGHT, LIGHTING MEANS WHICH CONTAINS SUCH A CONVERTER, AND METHOD FOR PRODUCING THE CONVERTER
CONVERTISSEUR POUR GÉNÉRER UNE LUMIÈRE SECONDAIRE À PARTIR D'UNE LUMIÈRE PRIMAIRE, MOYEN D'ÉCLAIRAGE CONTENANT DE TELS CONVERTISSEURS ET PROCÉDÉ DE FABRICATION DE CONVERTISSEURS

(30) Priorität: 18.12.2015 DE 102015122323; 13.04.2016 DE 102016106841
(43) Veröffentlichungstag der Anmeldung: 24.10.2018
(73) Patentinhaber: Fraunhofer-Gesellschaft zur Förderung der angewandten Forschung e.V., 80686 München (DE)
(72) Erfinder: HOFMANN, Ulrich, 25524 Itzehoe (DE); QUENZER, Hans-Joachim, 25524 Itzehoe (DE); LISEC, Thomas, 25524 Itzehoe (DE); VON WANTOCH, Thomas, 24114 Kiel (DE)
(74) Vertreter: Strehl Schübel-Hopf & Partner
(86) Internationale Anmeldenummer: PCT/EP2016/080762
(87) Internationale Veröffentlichungsnummer: WO 2017/102708

(56) Entgegenhaltungen:
- WO-A1-2009/136351
- WO-A1-2013/183751
- JP-A- 2013 207 049
- US-A1- 2006 261 360
- US-A1- 2013 016 499
- US-A1- 2014 071 683
- US-A1- 2014 158 982
- US-A1- 2015 184 830

## Beschreibung

Die vorliegende Erfindung betrifft Konverter ("Konverteranordnungen") zur Umwandlung eines Primärlichts in ein Sekundärlicht. Die Konverter sind dadurch gekennzeichnet, dass sie einen oder mehrere, häufig eine Vielzahl von Körpern aufweisen, die einfallendes oder durchtretendes Primärlicht in Sekundärlicht umwandeln. Je nach Anordnung können sie dieses Licht streuen oder gerichtet aussenden. Die Konverteranordnungen können sehr unterschiedliche Formen besitzen. So können sie z.B. eine Vielzahl extrem kleiner Körper (mit Abmessungen bis in den µm-Bereich hinein) aufweisen, die in Form von Arrays angeordnet sind, wobei jeder Körper durch den ihn umgebenden Rahmen vom benachbarten Körper getrennt vorliegt. In anderen Ausführungsformen können die Körper größer sein und Rahmen beliebiger Geometrie besitzen. Arrays mit einer Vielzahl der genannten Körper können mit entsprechenden Arrays optischer Bauteile wie Spiegeln oder Lasern zu Leuchtmitteln mit einer größeren Abstrahlfläche kombiniert werden. Alternativ lassen sich die Arrays vereinzeln oder Konverter mit nur einem oder wenigen lichtkonvertierenden Körpern herstellen; einzelne mit Rahmen umgebene Körper oder kleinere Arrays daraus können dann in mikroelektronischen Bauelementen verarbeitet werden. Die Erfindung ist jedoch nicht auf Konverteranordnungen für die Mikroelektronik beschränkt, vielmehr stellt sie auch größere Konverteranordnungen und entsprechende Leuchtflächen bereit.

Die erfindungsgemäßen Konverter können im Zuge der Herstellung von Bauelementen auf Siliziumbasis, ICs und dergleichen integriert werden, da sie mit Hilfe von in diesem Bereich üblichen Ätz-, Maskierungs- und Abscheidetechniken ausgeführt werden können.

Die sogenannte Remote-Phosphor-Technik gewinnt zunehmend an Bedeutung für moderne Beleuchtungssysteme. Sie beruht darauf, dass bestimmte Leuchtstoffe (Phosphore) einfallendes Licht einer bestimmten Wellenlänge mit hoher Effizienz in Licht einer anderen (längeren) Wellenlänge konvertieren können. Durch Mischen verschiedener Phosphore kann auf diese Weise zum einen weißes Licht erzeugt werden. Zum anderen können in Kombination mit Lichtquellen wie Halbleiterlasern Beleuchtungssysteme mit sehr hoher Intensität auf kleinstem Raum hergestellt werden. Bedingt durch Streueffekte in dem die Phosphore enthaltenden Konverter wird das Sekundärlicht vergleichsweise gleichmäßig über dessen Fläche abgestrahlt, selbst wenn das Primärlicht, wie im Falle eines Lasers, scharf gebündelt ist. Ein Beispiel dafür sind die neuen LARP (Laser Activated Remote Phosphor) Laser-Schweinwerfer des BMW i8, die eine sehr hohe Leuchtdichte aufweisen und die maximale Reichweite des Fernlichts (1-Lux-Grenze) von 320 m (LED-Fernlicht) auf 710 m erhöhen. Für LEDs und LED-basierte Leuchtmittel ist das ebenfalls von Vorteil, wie in Shani, "Fundamentals of planar remote phosphor LEDs", Luger Research e.U., Issue 29, 2012, beschrieben. Es wäre jedoch auch wünschenswert, die laterale Streuung bei Bedarf limitieren zu können, um möglichst punktförmige Sekundärlichtquellen zu erhalten.

Die Beschichtung blauer LEDs mit phosphorhaltigen Schichten zur Erzeugung weißen Lichtes wurde schon vor längerer Zeit von Cree eingeführt. Studien bezüglich der Konzentration der Phosphore und deren Dicke zur Erzielung von weißem Licht haben N. T. Tran et. al. in "Studies of phosphor concentration and thickness for phosphor-based white light-emitting-diodes", J. Lightwave Technol., Vol. 26, No. 21, 2008 unternommen. Anhand eines Materials, das blaue Wellenlängen absorbiert und gelb emittiert (YAG:Ce) und sich daher gut für die Lichtkonversion von blau emittierenden Si-LEDs eignet, wurden Phänomene wie die Brechungsindex-Differenz zwischen Phosphor und der umgebenden Matrix untersucht, was zu Streu-, Einfang- und Absorptionseffekten innerhalb des Bereichs führt, in dem sich der Phosphor befindet. Durch diese Effekte wird die Wirksamkeit der Phosphore verringert. Die theoretischen Studien wurden unter der Annahme simuliert, dass sphärische Phosphor-Partikel mit einem Matrixmaterial mit einem Brechungsindex von 1,46 vermischt in einem tassenförmigen Raumbereich unmittelbar oberhalb eines LED-Chips eingefüllt waren.

Die Effizienz der Lichtkonversion in direkt auf die LED aufgebrachten Konverterschichten leidet jedoch erheblich unter der von der LED abgegebenen Wärmeenergie. Außerdem kommt es zum Phänomen der Rückreflexion an den Oberflächen des schichtförmig aufgebrachten Phosphors. Um den Wärmeeintrag in die Phosphor-Schicht zu verringern, wird in der Remote-Phosphor-Konfiguration die phosphorhaltige Konverterschicht in einem gewissen Abstand zur LED platziert. Ebenfalls von N. T. Tran und Mitarbeitern wurde des Weiteren der Einfluss der Größe solcher Phosphor-Partikel auf die emittierte Lichtmenge und die Konversionseffizienz untersucht (Tran et. al, "Effect of phosphor particle size on luminous efficacy of phosphor-converted white LED", J. Lightwave Technol., Vol. 27, No. 22, 2009). Diese Untersuchungen erfolgten sowohl an Vorrichtungen, in denen das lichtkonvertierende Element unmittelbar in Kontakt mit der LED stand, als auch an Remote-Phosphor-Konstrukten. Mit Remote-Phosphor-Konfigurationen werden auch die Reflexions-Phänomene verringert, siehe Shani, a.a.O.

Zumeist werden die Phosphore mit organischen Materialien wie z.B. Silikon gemischt und als Dickschicht durch Drucken, Dispensieren oder Aufschleudern auf einen Träger aufgebracht. Es lassen sich auch freistehende Konverter beliebiger Form z. B. durch Spritzguss herstellen.

Mit steigender Lichtleistung kommt es aber auch in Remote-Phosphor-Konfigurationen zu Alterungseffekten. Einen wesentlichen Anteil daran hat die schlechte Wärmeleitfähigkeit und geringe thermische Stabilität der bei der Konverterherstellung verwendeten organischen Materialien. Von M. Meneghini et al. wurde in "Thermally activated degradation of remote phosphors for application in LED lighting", IEEE Transact. on Dev. and Mat. Reliability, Vol. 13, No. 1, 2013, nach einer Auslagerung bei 150°C sowohl für die Trägerplatte des Konverters, bestehend aus Polycarbonat, als auch die darauf befindliche Konverterschicht, basierend auf Silikon, eine drastische Degradation festgestellt. C.-C. Tsai et. al. konnten in "Ultra-high thermal-stable glass phosphor layer for phosphor-converted white light-emmiting diodes", J. Display Technol., Vol. 9, No. 6, 2013, zeigen, dass glasbasierte Phosphorschichten eine wesentlich höhere thermische Stabilität aufweisen als silikonbasierte und auch nach einer Auslagerung bei 350°C keine Degradation aufweisen. Problematisch ist jedoch, dass auch glasbasierte Phosphore wegen der hohen Herstellungstemperaturen chemisch oder thermisch bedingt degradieren können. Eine Lösung dieses Problems bietet DE 10 2013 226 630 A1. Dort wird beschrieben, dass sich unter Einsatz von Gläsern mit spezieller Zusammensetzung glasbasierte Konverterschichten bzw. -formkörper bei Temperaturen von 350-400°C erzeugen lassen. Ein weiterer Vorteil der Verwendung von Glas als Matrixmaterial ist, dass dessen Brechungsindex durch Zugabe entsprechender Elemente an den der Phosphore (ca. 1,8) angepasst werden kann. Dadurch wird die Lichtstreuung unterdrückt und somit die Lichtausbeute erhöht.

Hauptanwendung der Remote-Phosphor-Technik sind Beleuchtungssysteme auf der Basis von LEDs. Vergleichsweise große Konverter können z. B. mittels Spritzgießen hergestellt werden. Zur Herstellung kleiner Konverteranordnungen, die im Nutzen auf ein Substrat mit LEDs aufgebracht werden können, schlagen H. Liu et. al. in "LED wafer level packaging with a remote phosphor cap", Proc. EMAP, Lantau, Island, 2012, vor, eine Phosphor-Silikon-Paste in eine Aluminium-Form mit einer Vielzahl kleiner Vertiefungen zu drücken, die zuvor mit einem Trennmittel besprüht worden war. Nach dem Glätten der Oberfläche und Härten der Paste in einem Ofen konnte ein entsprechend strukturierter Film gewonnen werden. Dieser wird anschließend mit hochviskosem Silikon auf einem mit Durchbrechungen versehenen Deckelwafer montiert, der seinerseits auf einem Basiswafer aus Silicium mit vormontierten LEDs angebracht wird.

Für den strukturierten Auftrag können sowohl bei der Verwendung von Phosphoren in einer Glasmatrix (L. Yang et al., "Preparation of phosphor glass via screen printing technology and packaged performance for LEDs", Proc. ICEPT, Dalian, China, 2013) als auch in einer Silikonmatrix (J. C. C. Lo et. al., "Multilayer dispensing of remote phosphor for LED wafer level packaging with pre-formed silicone lens", Proc. ESTC, Helsinki, Finland, 2014) Pasten eingesetzt werden, die mit Techniken wie Siebdruck, Molding oder Dispensing aufgetragen werden können. Molding und Dispensing sind dabei eher für niedrigviskose Lösungen auf organischer Basis geeignet. Hochviskose Lösungen oder Pasten, wie z. B. glasbasierte Phosphore, lassen sich mittels Siebdruck gut aufbringen. Typische Abmessungen so erzeugter Konverteranordnungen liegen bei >100 µm.

Intelligente Beleuchtungssysteme gewinnen zunehmend an Bedeutung für Anwendungen wie z.B. Bildprojektoren oder adaptive Scheinwerfer. Viele Entwicklungen basieren auf Mikrospiegeln, die das Licht einer externen Quelle moduliert reflektieren. Das können einzelne Scanner-Spiegel mit ausreichend großer Auslenkung in x- und y-Richtung bzw. ausreichend hoher Scan-Frequenz sein. So beschreiben U. Hofmann et. al. in "A novel vacuum-packaged low-power scanning mirror with inclined 3D-shaped window", Proc. Transducers, Beijing, China, 2011, ein entsprechendes für Displayanordnungen entwickeltes Bauelement. Ein Scanner speziell für adaptive Scheinwerfer ist in T. Aoyagi et. al. "A raster-output 2D MEMS scanner with an 8x4 mm mirror for an automotive time-of-flight image sensor", Proc. Transducers, Barcelona, Spain, 2013, beschrieben. Eine andere Möglichkeit besteht in der Verwendung eines Arrays, bestehend aus sehr kleinen Spiegeln, die zwischen zwei Positionen hin und her gekippt werden. Ein Beispiel dafür ist die DLP-Technologie von Texas Instruments, basierend auf ca. 10x10 µm² großen Mikrospiegeln aus Aluminium. Mittlerweile sind DLP-Chips mit bis zu 2560x1600 Einzelelementen kommerziell verfügbar.

Im Artikel von V. Milanovic et al. " High brightness MEMS mirror based head-up display (HUD) modules with wireless data streaming capability" Proc. SPIE Conf. on MOEMS and Miniaturized Systems XIV, San Francisco, CA, 2015, wird über die Verwendung eines phosphorbasierten Konverters in Kombination mit einem MEMS-Mikrospiegel für ein Head-Up-Display berichtet. Der modulierte Lichtstrahl einer einzelnen Laserquelle wird dabei zuerst auf die Konverterplatte und erst danach das Sekundärlicht über einen Falt-Spiegel auf die eigentliche Projektionsfläche (Frontscheibe eines Fahrzeuges) projiziert. Nachteilig ist, dass die Abbildung durch die Lichtstreuung im ganzflächig aufgebrachten Phosphor an Schärfe verliert.

Dokument US 2013/016499 A1 offenbart eine Konverteranordnung, die einen Rahmen und eine lichtkonvertierende offenporige Struktur umfasst. Das Dokument US 2013/016499 A1 offenbart auch eine anorganische Schutzschicht und eine weitere transparente Schicht, die die lichtkonvertierende offenporige Struktur bedecken.

Ein besseres Ergebnis kann erzielt werden, wenn die Konverterplatte mit einer Anordnung separater Leuchtstoffpunkte (Bildpunkte, Pixel) versehen ist, wie in DE 10 2013 226 650 A1 offenbart. In dieser Druckschrift ist in Kombination mit einer Konverterplatte mit separaten Pixeln auch der Einsatz von MEMS-Spiegeln zur Modulation des Primärlichts (Laserstrahls) vorgesehen. Auf Verfahren zur Herstellung der Konverterpixel wird nicht eingegangen.

Der vorliegenden Erfindung liegt die Aufgabe zugrunde, Konverter mit lichtkonvertierendem Material zur Umwandlung eines Primärlichts in ein Sekundärlicht bereitzustellen, die sich für die sog. "Remote-Phosphor"-Technik eignen und eingetretenes Licht in gewünschtem Maße streuen. Dann, wenn die Konverter-Arrays einer Mehrzahl oder Vielzahl von einzelnen lichtkonvertierenden Arealen auf engem Raum und ggf. mit sehr geringen Größen (z.B. mit Abmessungen im µm-Bereich) aufweisen, sollen diese Areale so zueinander ausgerichtet sein, dass sie ohne zusätzliche Maßnahmen keinen unmittelbaren optischen Kontakt zueinander besitzen und somit ein seitliches "Übersprechen" ausgeschlossen ist. Die Konverter sollen sich in ihrer Grundform vorzugsweise mit rein anorganischen Materialien herstellen lassen, gegebenenfalls aber geeignet sein, an Materialgrenzflächen mit organischen Materialien zusammenzuwirken. Sie sollen vorzugsweise in einem Temperaturbereich herstellbar sein bzw. Temperaturen aushalten, die Anwendungen in der klassischen Mikroelektronik-Mikrooptik wie in siliziumbasierten Chips oder ICs ermöglichen.

In Lösung der Aufgabe stellen die Erfinder Konverter zur Umwandlung eines Primärlichts in ein Sekundärlicht bereit. Die Erfindung ist im beigefügten Anspruchssatz beschrieben.

Die Konverteranordnung umfasst mindestens einen Körper, der eine lichtkonvertierende Struktur mit offenen Poren aufweist und seitlich von einem Rahmen gehalten wird, wobei die Oberflächen sowohl der lichtkonvertierenden Struktur als auch der Innenseiten des Rahmens mit einer transparenten anorganischen Schicht, vorzugsweise einer Schicht aus einer Metallverbindung, bedeckt sind. Die Bedeckung ist in der Regel vollständig.

Im Ausdruck "lichtkonvertierende Struktur mit offenen Poren" soll zum Ausdruck kommen, dass die lichtkonvertierende Struktur als solche nicht als Monolith, sondern offenporig vorliegt. Das soll aber nicht unbedingt bedeuten, dass die in der lichtkonvertierenden Struktur vorhandenen Poren "leer", also mit Gas gefüllt oder evakuiert sein müssen. Stattdessen können sie teilweise oder vollständig mit einem organischen Material verfüllt sein, wie weiter unten näher erläutert. Die Erfindung wird nachfolgend u.a. anhand von Figuren näher erläutert, die folgendes zeigen:
**Fig. 1** stellt schematisch eine mögliche Herstellung von Konvertern (substratgestützt) dar,
**Fig. 2** zeigt auf der linken Seite einen durch Siebdruck erzeugten Konverter ohne Rahmen um die einzelnen lichtkonvertierenden Areale und auf der rechten Seite einen erfindungsgemäßen Konverter, bei dem jedes Areal mindestens von einem Rahmen umgeben ist,
**Fig. 3** zeigt die Möglichkeiten der Einkopplung von Primärlicht in eine erfindungsgemäße Konverteranordnung,
**Fig. 4** zeigt einen Konverter, bei dem das Substrat unterhalb der porösen lichtkonvertierenden Körper entfernt wurde,
**Fig. 5a****-e und c'-e'** stellt schematisch eine mögliche Herstellung von erfindungsgemäßen Konvertern dar, deren Rahmen zur Verbesserung der Reflexion seitlich metallisiert sind, einmal mit und einmal ohne Aperturblende,
**Fig. 6** zeigt zwei mögliche Konverteranordnungen mit Aperturblenden ("pinholes"), die als miniaturisierte Punktlichtquellen dienen können,
In **Fig. 7** sind zwei Konverteranordnungen mit geneigten Seitenflächen gezeigt, in Fig. 14a mit pinhole und Metallisierung auf den Innenseiten der Kavität und in Fig. 14b nur mit metallisierten Seitenflächen,
in **Fig. 8a** **bis c** sind Konverteranordnungen mit Mikrolinsen zur Fokussierung und/oder Kollimierung des Primärlichts (Fig. 8a) oder des Sekundärlichts (Fig. 8b) gezeigt. Figur 8c zeigt eine Anordnung mit beidseitig aufgebrachten Mikrolinsen,
**Fig. 9** zeigt eine Konverteranordnung mit einer planaren, beidseitig entspiegelten Abdeckung,
**Fig. 10** zeigt eine Konverteranordnung in Analogie zum Bildschirm eines Fernsehers, bestehend aus einem Array von Gruppen (Bildpunkten) mit jeweils drei lichtkonvertierenden Arealen mit unterschiedlichen lichtkonvertierenden Eigenschaften,
**Fig. 11** stellt eine schematische Draufsicht auf ein Array aus gleichartigen lichtkonvertierenden Arealen mit einfacher Geometrie dar,
**Fig. 12** stellt eine solche Draufsicht auf ein Array aus lichtkonvertierenden Arealen dar, die unterschiedliche Formen, Geometrien und Größen besitzen,
**Fig. 13** zeigt den prinzipiellen Aufbau einer adaptiven Lichtquelle, eines Displays bzw. einer Werbetafel unter Verwendung von erfindungsgemäßen Konverterarrays,
**Fig. 14** zeigt den prinzipiellen Aufbau eines miniaturisierten Projektors unter Verwendung eines erfindungsgemäßen Konverterarrays und eines MEMS-Scanners,
**Fig. 15** zeigt ein Array von Punktlichtquellen, deren Sekundärlicht in unterschiedlichen Spektralbereichen liegt,
**Fig. 16** ist eine schematische 3D-Ansicht und ein Querschnitt durch ein farbiges Mikrodisplay, und
**Fig. 17** ist eine schematische 3D-Ansicht und ein Querschnitt durch eine Anordnung, die aus einem einzelnen LED-Chip und einem darüber aufgebrachten Chip mit komplexer Konverterstruktur besteht.

Die erfindungsgemäße Konverteranordnung besitzt aufgrund ihrer porösen Struktur eine Vielzahl von inneren, gekrümmten Oberflächen, an denen das eintretende und auch das bereits konvertierte Licht gestreut werden. Die transparente anorganische Schicht aus einer Metallverbindung sorgt dabei für einen guten Korrosionsschutz des lichtkonvertierenden Materials, was aufgrund der großen inneren Oberflächen der Körper, die ja in der Regel mit der umgebenden Atmosphäre in Kontakt stehen, von besonderer Bedeutung ist.

Die Anzahl der Körper in einer Konverteranordnung kann stark schwanken und gegebenenfalls sehr hoch sein. In allen Fällen ist jeder Körper seitlich von einem Rahmen umgeben, der innenseitig, also zum Körper hin, ebenfalls von der genannten transparenten Schicht bedeckt ist. Gegebenenfalls kann der oder jeder der Körper (oder aber auch nur ein Teil der Körper) außerdem auf einem Substrat aufliegen und von diesem gestützt sein, das auch die Rahmenstruktur(en) bildet. Eine einzelne Konverteranordnung kann in einer ersten Ausführungsform eine Vielzahl extrem kleiner solcher Körper (mit Abmessungen bis in den µm-Bereich hinein) aufweisen, die in Form von Arrays angeordnet sind, wobei jeder Körper durch den ihn umgebenden Rahmen vom benachbarten Körper getrennt vorliegt. In anderen Ausführungsformen können die Körper größer sein und Rahmen beliebiger Geometrie besitzen.

Jeder der genannten Körper ist in der Regel durchgehend mit Poren durchsetzt, wobei die Poren in Form und Größe in der Regel unterschiedlich sind. Generell werden Form und Größe der Poren durch Form und Größe der bei der Herstellung verwendeten Partikel bestimmt. Da die Partikel meist nicht alle gleich sind, streuen Form und Größe der Poren innerhalb eines Körpers zufällig um ein statistisches Mittel. Jedoch kann auch ein Gradient in Richtung der freien Oberfläche eingestellt werden, z. B. bei Sedimentation der Partikel aus einer Lösung.

Der Rahmen besitzt in der Regel eine ebene Unter- und Oberseite; das von ihm umfasste Volumen kann vollständig oder teilweise mit dem Körper befüllt sein. Dessen Geometrie und der Befüllungsgrad werden je nach Bedarf gewählt. Die einzelnen Körper können eine hohe Strukturtiefe besitzen, und/oder die Rahmen können völlig mit den Körpern ausgefüllt sein.

Jeder Körper der Konverteranordnung bildet ein Areal, in welchem eine Eigenschaft des einfallenden Lichts, vorzugsweise dessen Wellenlänge, verändert wird. Vorzugsweise sind die einzelnen Areale der Konverteranordnung an die Struktur des Bau- oder Beleuchtungselements angepasst, für das sie vorgesehen ist. Im Falle eines Bauelements mit sehr kleinen Primärlichtquellen, wie Lasern oder Mikrospiegeln, wird man beispielsweise die Fläche der Areale auf die Fläche der Primärlichtquellen (z.B. Laser oder Mikrospiegel) abstimmen. Diese Fläche kann quadratisch, rechteckig, rund oder von einer anderen, beliebigen Form sein und beispielsweise Abmessungen von ca. 10 x 10 µm oder sogar noch darunter besitzen. Natürlich können die Abmessungen auch größer sein, beispielsweise bis zu 100 x 100 µm und mehr; zunehmend werden entsprechende Bau- oder Beleuchtungselemente jedoch eher mit noch kleineren Lichtquellen ausgebildet, sodass die Areale häufig Flächen von ca. 50 x 50 µm und darunter einnehmen werden. Die Tiefe der Areale kann wesentlich größer sein als ihre Länge und/oder Breite und beispielsweise etwa 100 - 1000 µm betragen. Dies ist jedoch keinesfalls zwingend. Die Areale können auch eher flach gestaltet sein, d.h. die Tiefe kann kleiner sein als ihre Länge und /oder Breite, wenn das für eine höhere Wirkung von Vorteil ist. Häufig besitzen die Areale einer Konverteranordnung identische Abmessungen. Dies muss jedoch nicht sein; eine alternative Ausgestaltung wird weiter unten beschrieben.

Das Material des porösen Körpers mit lichtkonvertierenden Eigenschaften wird je nach Bedarf ausgewählt. Es handelt sich dabei vorzugsweise um ein lumineszierendes Material, das nachstehend auch als Phosphor bezeichnet wird. Dessen Zusammensetzung kann frei gewählt werden. So können zur Erzeugung von weißem Licht aus blau emittierenden Si-LEDs die von N. T. Tran a.a.O. untersuchten YAG:Ce-Materialien verwendet werden. Dies ist jedoch nur ein Beispiel, der Fachmann kennt eine Vielzahl von lichtkonvertierenden Materialien, die dem Grunde nach ebenfalls für die Erfindung in Frage kommen. So sind für Beleuchtungs- sowie Display-Anwendungen sind neben den gelben Phosphoren auch die roten (z.B. CaAlSiN₃:Eu²⁺, CASN) sowie blauen (z.B. Sr3MgSi208:Eu2+, SMS) und grünen (z.B. Ba2SiO4:Eu2+, BSO) Phosphore von Interesse. Grundsätzlich können alle kommerziell erhältlichen und einsetzbaren Phosphore verwendet werden. Zur Herstellung der porösen Körper können aber auch Partikel aus Gläsern oder anderen Matrixmaterialien eingesetzt werden, die chemisch homogen oder physikalisch homogen verteilte lumineszierende Verbindungen, Verbindungscluster oder Nanopartikel enthalten. In einer wiederum anderen Ausführungsform können die Oberflächen der Körper, d.h. auch die im Inneren der Körper enthaltenen Poren, mit lumineszierendem Material beschichtet sein. Das Material mit lichtkonvertierenden Eigenschaften ist vorzugsweise ein rein anorganisches Material, es kann in seltenen Fällen aber auch organische Komponenten besitzen.

Die Konverteranordnungen der vorliegenden Erfindung können in einer ersten Ausgestaltung des diesbezüglichen Herstellungsverfahrens mit Hilfe von Partikeln erzeugt werden, die lose in die entsprechenden Rahmen eingefüllt und anschließend mit der transparenten Schicht aus anorganischem Material verbunden wurden. Die Partikel sind vorzugsweise aus rein anorganischem Material aufgebaut; da die nachstehend näher beschriebene Verbindung der Teilchen untereinander bei relativ milden Temperaturen (maximal 400°C, in einigen Fällen nur bis zu 150°C oder gar 60°C, z.B. im Falle der Abscheidung von Al₂O₃ mittels ALD) erzeugt werden kann, können aber auch organische Materialien eingesetzt werden, soweit diese die genannten Temperaturen ohne Zersetzung oder nennenswerte Alterung ertragen.

Die Partikel können aus einem einzigen Material bestehen, es kann jedoch auch ein Gemisch von Partikeln aus unterschiedlichen Materialien eingesetzt werden. Werden Partikelgemische aus zwei oder mehr Partikelarten eingesetzt, können beide oder alle der Partikelarten aus einem lichtkonvertierenden Material bestehen, beispielsweise, um Sekundärlicht einer bestimmten Farbe zu erhalten. Alternativ oder kumulativ kann es von Vorteil sein, lichtkonvertierende Partikel mit Partikeln aus einem Material zu mischen, das nicht direkt zur Lichtkonversion vorgesehen ist, das jedoch insgesamt gesehen eine Verbesserung der Konvertereigenschaften herbeiführt, indem es z. B. Lichtstreuung und -absorption optimiert. Da, wie oben erwähnt, die lichtkonvertierenden Partikel auch selbst das Sekundärlicht wieder absorbieren, hat deren Konzentration einen Einfluss auf die Konvertereffizienz, wie von N. T. Tran a.a.O. beschrieben. In einer Ausführungsform der Erfindung werden daher lichtkonvertierende Partikel mit Partikeln gemischt ("verdünnt"), die aus einem optisch transparenten, jedoch nicht lichtkonvertierenden Material mit vorgegebenem Brechungsindex bestehen. Prinzipiell kann auch eine weitere Art von optisch transparenten, jedoch nicht lichtkonvertierenden Partikeln beigemischt werden, die einen von den ersten beiden Partikelarten abweichenden Brechungsindex aufweisen und als Streuzentren für eine optimale Streuung des Primärlichts innerhalb der Konverterstruktur dienen. Meistens ist das Beimischen von Streuzentren jedoch nicht erforderlich, da das Vorhandensein von luftgefüllten Poren zwischen den Partikeln für eine ausreichende Lichtstreuung sorgt. Es kann im Gegenteil erforderlich sein, die Lichtstreuung innerhalb der porösen Konverterstrukturen zu unterdrücken. Das kann z. B. durch Aufbringen einer Antireflektionsschicht erfolgen, die auch die gesamte innere Oberfläche der porösen Konverterstruktur bedeckt. Wie bei der Erzeugung der porösen Strukturen kann das z.B. mittels ALD geschehen.

Die Größe der Partikel ist nicht kritisch, sie beeinflusst aber die Konvertereffizienz. Die diffuse Abstrahlung und die Emissionsstrahlung der Partikel sind nicht notwendigerweise identisch. Eingestrahltes Licht wird absorbiert (von den Wänden des Konverters, von den lichtkonvertierenden Partikeln und ggf. von den "verdünnenden" Partikeln). N. T. Tran haben in ihrem Artikel in Journal of Lightwave Technology, a.a.O., das Verhalten von Partikeln mit Durchmessern zwischen 0,05 und 50 µm in zwei spezifischen geometrischen Umgebungen untersucht. Die Partikel lagen dabei in einer Matrix vor, deren Brechungsindex um 0,34 von dem der Partikel abwich. Die Lichtleistung stieg ab einem Durchmesser von ca. 0,5 µm bis zu einem Maximum bei ca. 20 µm und sank dann wieder ab. Aber auch andere Effekte spielen eine Rolle. Die Erfindung ist nicht auf Partikeldurchmesser wie von N. T. Tran et al. beschrieben beschränkt; es hat sich jedoch herausgestellt, dass Konverter mit günstigen Eigenschaften erhalten werden, wenn die Partikel Größenbereiche zwischen ca. 1 und 100 µm vorzugsweise zwischen ca. 5 und 50 µm und stärker bevorzugt von zwischen ca. 8 und 30 µm Durchmesser (durchschnittlicher Wert) besitzen. Günstig ist es, wenn die Partikel eine runde oder annähernd sphärische oder rundlich-längliche (eiförmige) Form aufweisen. Ein notwendiges Kriterium ist dies jedoch nicht, fördert aber die Ausbildung einer regelmäßigen Porenstruktur. Auch sollte in sehr kleinen Konverterarealen darauf geachtet werden, dass mehr als ein und vorzugsweise mindestens 10 Partikel nebeneinander zu liegen kommen können, es können aber natürlich auch sehr viel mehr sein. Mit anderen Worten, die Größe der verwendeten Partikel sollte auf die Größe der Konverterareale abgestimmt sein.

Die Partikel können auf beliebige Weise in die Areale der Konverterstruktur gelangt sein, beispielsweise durch Aufrieseln, durch Rakeln des trockenen Materials oder eines Schlammes oder Dispensieren einer Suspension oder eines Schlammes, wobei eventuell vorhandenes Suspensionsmittel bzw. andere Flüssigkeiten anschließend abgedampft werden, bevor die Verfestigung durchgeführt wird.

Die Körper der erfindungsgemäßen Konverteranordnungen müssen nicht notwendigerweise aus Partikeln aufgebaut sein. Alternativ ist es möglich, poröse lichtkonvertierende Materialien einzusetzen, die sich auf andere Weise herstellen lassen. Werden lichtkonvertierende Materialien auf Glasbasis oder in einer Glasmatrix eingesetzt, können z.B. bekannte Techniken zur Herstellung von Glasfritte bzw. porösen Gläsern genutzt werden wie das Vycor-Glas-Verfahren (ein Verfahren, bei dem phasengetrennte Alkaliboratgläser durch Extraktion einer löslichen Phase porös gemacht werden).

Die lichtkonvertierenden Körper der erfindungsgemäßen Konverterstrukturen sind in den einzelnen Arealen mit einer transparenten anorganischen Schicht bedeckt. Auch wenn der Körper mit Hilfe von pulverförmigen Partikeln hergestellt wurde, liegen diese also nicht lose oder verschiebbar nebeneinander. Dabei ist die Festigkeit der durch die Schicht bewirkten Verbindung der Partikel untereinander, wenn diese als Ausgangsmaterial dienten, so groß, dass die Körper als Ganzes aus den Arealen herausgenommen und z.B. mit einer Pinzette gehalten werden können, ohne auseinanderzubrechen. Die Verbindung der Partikel, wenn diese als Ausgangsmaterial dienten, ist damit unter normalen Bedingungen (d.h. ohne äußere Krafteinwirkung) stabil und hält auch leichten mechanischen Einwirkungen stand.

Das Material der transparenten Schicht ist frei von organischen Bestandteilen. Stärker bevorzugt besteht die Schicht aus einer Metallverbindung, vorzugsweise einem Metalloxid; es kann sich jedoch auch um ein Metallnitrid oder ein Metallcarbid oder eine Kombination (z.B. ein Oxinitrid oder ein Carbonitrid) aus den vorgenannten Materialien oder dergleichen handeln. Je nach Bedarf kann dieses Material unter eher niedriger brechenden Oxiden wie z.B. Aluminiumoxid oder Siliciumoxid oder unter eher höherbrechenden Oxiden wie Titandioxid oder Zirkoniumdioxid gewählt werden, um geeignete Reflexionseigenschaften einzustellen. Wie schon erwähnt kann es erforderlich sein, die Lichtstreuung an den Übergängen zwischen Partikeln und luftgefüllten Poren innerhalb der porösen Konverterstrukturen mittels einer Antireflektionsbeschichtung zu unterdrücken. Diese kann aus einer einzelnen Schicht oder einer Schichtfolge bestehen.

Die Abscheidung der transparenten anorganischen Schicht erfolgt mittels eines chemischen Dampfabscheideverfahrens (chemical vapor deposition, CVD). Insbesondere hat sich die Abscheidung durch ALD (Atomlagen-Abscheidung, atomic layer deposition) als günstig erwiesen. Bei dieser werden nacheinander zwei verschiedene Komponenten im gasförmigen Zustand in den Reaktionsraum eingeleitet. Nachdem sich die erste Komponente in einer monomolekularen Schicht an der Oberfläche der Partikel angelagert hat und der Reaktionsraum wieder abgepumpt wurde, kommt es nach Einleitung der zweiten Komponente zur Reaktion mit der auf der Oberfläche absorbierten ersten Komponente und zur Bildung einer nur wenige Angström dicken Schicht. Durch vielfaches Widerholen dieser Prozedur wird eine besonders gleichmäßige Schicht erzeugt. Die Schichtdicke wird hauptsächlich über die Zahl der Beschichtungsvorgänge eingestellt. Daher sind auch Schichtkombinationen aus verschiedenen Materialien leicht realisierbar. Wird ALD zur Herstellung der Schicht eingesetzt, genügen in manchen Fällen bereits Schichtdicken von nur 5 nm, um eine mechanisch stabile Verfestigung zu erreichen, wenn als Ausgangsmaterial für den Körper lichtkonvertierende Partikel eingesetzt wurden. Günstig sind Schichtdicken von mindestens 10 nm oder mehr, beispielsweise im Bereich von 50 bis 100 nm. Die Schichtdicke ist nach oben jedoch theoretisch nicht begrenzt; die Schicht kann ggf. so dick werden, dass die Poren innerhalb des Körpers auf die Hälfte ihres ursprünglichen Volumens oder noch weniger zusammenschrumpfen oder sogar ganz mit dem Schichtmaterial befüllt werden. Mit der letztgenannten Maßnahme lässt sich die Streuwirkung der erfindungsgemäßen Konverteranordnung gezielt beeinflussen.

Der Vorteil der Herstellung der Körper mit Hilfe von Partikeln liegt darin, dass lose Partikel aus lichtkonvertierendem Material bzw. geeignete Partikelgemische bequem in mehrere Vertiefungen/Formen bzw. Kavitäten eines Substrats eingefüllt und dort verfestigt werden können. Die entsprechende Technik ist aus WO 2012/104106 A1 bekannt. Das Substrat kann vor der Befüllung vorbehandelt oder anschließend chemisch oder mechanisch weiterverarbeitet und mit anderen Komponenten eines späteren Bauelements kombiniert werden, was nachstehend für eine Vielzahl von möglichen Ausgestaltungen näher erläutert werden wird.

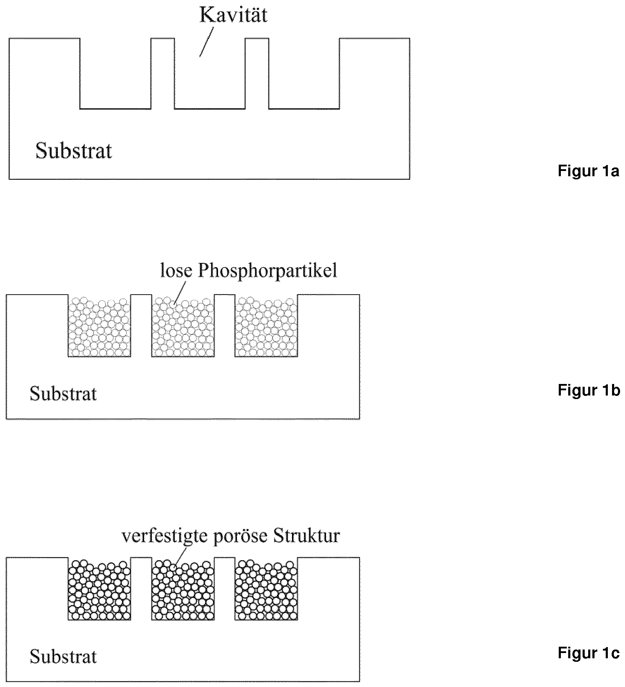

Die entsprechenden Verfahrensschritte zur Herstellung des/der Konverter(s) sind in **Figur 1** schematisch dargestellt: Gemäß Schritt (a) wird ein Array von Kavitäten entsprechend den Abmessungen der Konverteranordnung in einem Substrat bereitgestellt bzw. ausgebildet. Das kann z.B. durch Trockenätzen eines Si-Substrats mittels Lackmaske erfolgen. Im nächsten Schritt (Schritt (b)) werden die Kavitäten mit losen lichtkonvertierenden Partikeln befüllt. In Schritt (c) werden die losen lichtkonvertierenden Phosphorpartikel sodann zu festen, porösen Strukturen verfestigt. Die transparente, mechanisch stabile Schicht ummantelt alle lichtkonvertierenden Phosphorpartikel, die sich in jeder einzelnen Kavität befinden.

Mit dem Verfahren der WO 2012/104106 A1 gelingt es, selbst µm-große Partikel bis auf den Boden einer mehrere 100 µm tiefen Kavität vollständig mit einer homogenen Schicht zu ummanteln. So lässt sich mit diesem Verfahren beispielsweise eine poröse Struktur aus monodispersen, kugelförmigen oder annähernd kugelförmigen Partikeln mit ca. 10 µm Durchmesser erzeugen. Zur Verfestigung kann eine Schicht aus einem geeigneten Material, beispielsweise einem Oxid wie Al₂O₃, mit einer Dicke von nur 75 nm bei 300°C abgeschieden werden, zum Beispiel mittels ALD. Die Erfinder konnten anhand geeigneter Versuche, z.B. mit einer Kavität mit einer Fläche von 1200 x 1200 µm und einer Tiefe von ca. 400 µm, feststellen, dass selbst dann, wenn die Dicke der ALD-Schicht nur ca. 1 % des Partikeldurchmessers beträgt, sich die Partikel auch unter Schock (Herunterfallen) nicht aus der Kavität herauslösen. Sie konnten auch nachweisen, dass die ALD-Schicht alle Oberflächen der Teilchen bedeckt, da der Körper ausschließlich offene Poren besitzt. Diese Schicht verbindet die Partikel an denjenigen Punkten fest und mechanisch stabil, an denen sie aneinanderstoßen.

Die freistehenden porösen Strukturen sind erstaunlich fest. Eine Handhabung mit einer herkömmlichen Pinzette ist möglich.

Das Trägermaterial der Trägerstrukturen wird je nach Bedarf gewählt. Da Silizium gut ätzbar ist und sich zur Wafer- und Chipherstellung eignet, kann der Träger aus Silizium bestehen. Es sind aber auch andere Trägermaterialien möglich, sofern diese die Beschichtungstemperaturen von maximal etwa 400°C, vorzugsweise 250°C oder sogar nur 60°C, wie oben beschrieben, aushalten, ohne einen für das spätere Produkt nachteiligen Schaden zu erleiden.

Wie erwähnt, werden in der Regel sowohl die Partikel als auch das Trägermaterial unter rein anorganischen Materialien ausgewählt, auch wenn dies nicht in allen Fällen zwingend ist. Die Beschichtung der Partikel ist ebenfalls anorganisch; sie besteht häufig aus einem Oxid, Nitrid oder Oxinitrid des Aluminiums oder eines anderen Metalls.

Die Poren zwischen den Partikeln können im Wesentlichen frei bleiben (sie sind dann mit der Gasatmosphäre befüllt, die im Konverter bzw. im Bauelement herrscht, das den Konverter enthält, ggf. auch bei anderen als Umgebungsdrücken, beispielsweise Unterdruck): Wenn, wie oben beschrieben, die Dicke der Beschichtung nur ca. 1% des Durchmessers der Partikel ausmacht, wird das Porenvolumen durch den Beschichtungsvorgang kaum verringert. Eine solche Verringerung kann jedoch bei Bedarf herbeigeführt werden, indem entweder die Beschichtung wesentlich dicker gemacht wird, wie oben beschrieben. Alternativ kann das Porenvolumen nachträglich auch mit einem organischen Material verfüllt werden.

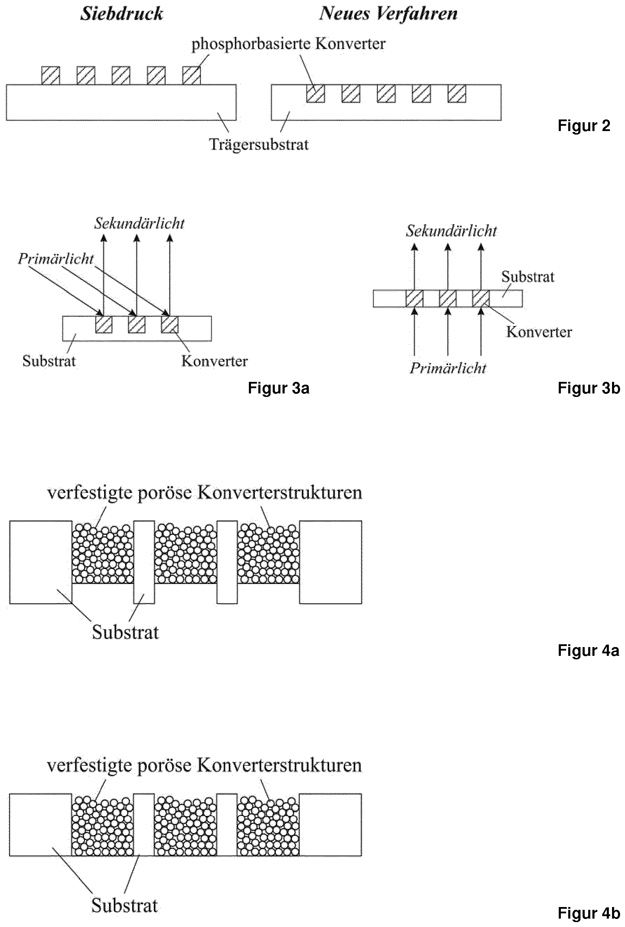

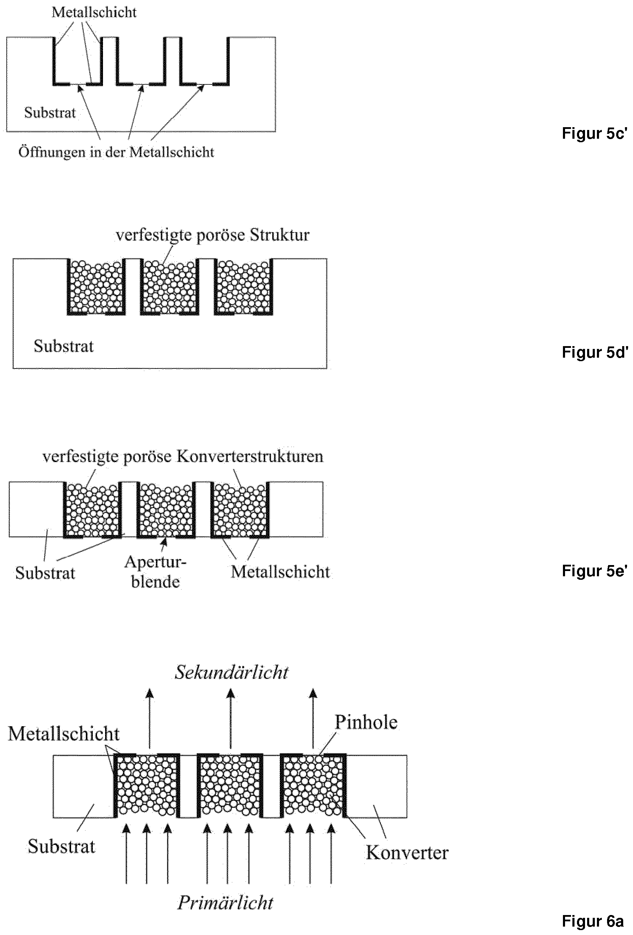

Die erfindungsgemäßen Konverteranordnungen besitzen unter anderem die folgenden Vorteile:
- Soweit sie frei von organischen Materialien sind, können sie in weiteren Verarbeitungsstufen auch wesentlich höheren Temperaturen ausgesetzt werden, sofern die für die Lichtkonversion verantwortlichen Materialien dies zulassen.
- Die Herstellungstemperatur der Konverteranordnung ist bei einer Herstellung gemäß WO 2012/104106 A1 vergleichsweise niedrig, so dass auch thermisch empfindliche lichtkonvertierende Materialien nicht degradieren. ALD-Abscheidungen erfolgen typischerweise bei Temperaturen zwischen 100°C und 300°C. Für die Herstellung herkömmlicher "Remote-Phosphor"-Anordnungen aus glasbasierten Phosphoren werden dagegen auf jeden Fall Temperaturen über 400°C, oftmals sogar über 600°C benötigt, um ein Gemisch von Phosphor- und Glaspartikeln zu einer einheitlichen Masse zu verschmelzen. Erfindungsgemäß kann auf Verarbeitungsschritte wie Schmelzvorgänge im Herstellungsgang der Konverteranordnungen verzichtet werden, wenn die lichtkonvertierende Struktur mit offenen Poren z.B. durch das "Verkleben" von (z.B. gesinterten) Partikeln mit Hilfe von CVD-Verfahren wie ALD erzeugt wird. Bei Anwendung des vorgenannten Verfahrens kommt es auch nicht zu Schrumpfungseffekten.
- Es können einzelne Konverterareale mit lateralen Abmessungen deutlich unter 100 µm hergestellt werden. Gleichzeitig kann deren Tiefe (Höhe) mehrere 100 µm betragen.
- Die einzelnen "Konverterpixel" (vorstehend als "Areale" bezeichnet) sind in ein Trägermaterial eingebettet, so dass im Unterschied zu siebgedruckten Arrays das seitliche Übersprechen zwischen benachbarten Pixeln reduziert wird, wenn das Substratmaterial selbst nicht transparent bzw. entsprechend beschichtet ist. Ein Vergleich der erfindungsgemäßen Konverter-Arrays mit siebgedruckten Arrays ist in **Figur 2** dargestellt.
- Insbesondere kleine Konverteranordnungen können effektiv gekühlt werden, wenn das Trägermaterial aus einem gut wärmeleitenden Material wie z. B. Metall, Silizium oder Keramik besteht. Deren Wärmeleitfähigkeit ist um Größenordnungen höher als die von Silikon, Kunststoffen oder Glas.
- Durch die allseitige Ummantelung mit der transparenten, anorganischen Schicht werden die lichtkonvertierenden Partikel vor Korrosion geschützt.

In einer spezifischen Ausgestaltung der Erfindung wird die Schicht, die die lichtkonvertierenden Partikel verbindet, als Antireflexschicht genutzt. Dies lässt sich beispielsweise mit oxidischen Materialien wie TiO₂, SiO₂ oder Al₂O₃ realisieren, deren Antireflexeigenschaften in dünnen Schichten bekannt sind. Vorzugsweise werden diese Schichten mittels ALD abgeschieden, da sich auf diese Weise auch alle inneren Oberflächen der porösen Strukturen beschichten und sehr gut definierte Schichtdicken erzielen lassen. Auf diese Weise können Verluste innerhalb der Konverteranordnung minimiert werden, ohne dass die Zwischenräume zwischen den Phosphorpartikeln mit einem Material mit angepasstem Brechungsindex verfüllt werden müssen.

In einer alternativen Ausgestaltung der Erfindung werden die Poren innerhalb der einzelnen Areale der Konverterstruktur nach der Abscheidung der verbindenden Schicht mit einer organischen Füllmasse verfüllt. Außerdem kann die Oberfläche eines, mehrerer oder aller Körper oder die gesamte Konverterstruktur mit einer einlagigen oder mehrlagigen Beschichtung versehen werden. Durch solche Maßnahmen kann zum einen die mechanische Stabilität, insbesondere gegenüber thermomechanischen Stress etwa bei Temperaturwechselbelastungen, verbessert werden. Zum anderen kann die unter Umständen mögliche Kondensation von Wasser innerhalb der porösen Partikelmatrix unterbunden werden (Hydrophobisierung). Die gute Wärmeleitung innerhalb des Partikelverbunds wird hierdurch nicht beeinträchtigt. Das Auffüllen der Poren mit einer organischen Füllmasse, z. B. aus einem Epoxidharz, Silikon oder Polyimid, kann auch dabei helfen, optische Verluste an den Grenzflächen zu vermeiden. Zusammen mit der Beschichtung der Partikel mit einer Antireflexschicht können dadurch höhere Lichtausbeuten erzielt werden.

Es gibt verschiedene Möglichkeiten, das Primärlicht in einzelne erfindungsgemäße KonverterAreale oder in Arrays solcher Areale einzukoppeln und das erzeugte Sekundärlicht auszukoppeln. **Figur 3** zeigt zwei dieser Möglichkeiten. Für die Ausgestaltung der **Figur 3a** wurden die lichtkonvertierenden Partikel in vorgefertigte, z.B. vorgeätzte Vertiefungen eines Trägers, hier eines Substrates, eingefüllt und anschließend durch die Aufbringung der Beschichtung wie oben beschrieben, verfestigt. Diese Ausgestaltung ist hinsichtlich der Kühlung der Konverter gegenüber der Ausgestaltung der **Figur 3b** vorteilhafter, sofern das Substrat aus einem gut wärmeleitenden Material besteht. In der Ausgestaltung der **Figur 3b** ist das Substrat unterhalb der Konverteranordnungen entfernt worden, beispielsweise durch Ätzen oder Schleifen, sodass das Primärlicht von unten eingekoppelt werden kann. Dadurch ergeben sich neue Möglichkeiten bezüglich der Anordnung der optischen Komponenten eines Beleuchtungssystems, die in den nachfolgenden Ausführungen näher beschrieben werden.

Wie voranstehend erwähnt, kann das Entfernen des Substrats unterhalb der Konverteranordnungen auf verschiedene Weisen erfolgen. In der Ausgestaltung der **Figur 4a** ist die Substratdicke in den die Konverterareale umgebenden und diese tragenden Bereichen unverändert geblieben; das Substrat ist aber unterhalb der Areale entfernt worden. Im Falle eines Si-Substrats kann das z.B. mittels Trockenätzen mit Lackmaske von der Rückseite her erfolgen. In **Figur 4b** ist das ursprüngliche Substrat bodenseitig ganzflächig entfernt worden, was im Falle von Si-Substraten z.B. mittels Schleifen und Polieren erfolgen kann. Variante (b) ist die etwas einfachere, da auf der Rückseite des Substrats keine zusätzliche Lackmaske erforderlich ist. Nachteilig ist jedoch, dass unter Umständen die transparente anorganische Schicht auf der äußersten Oberfläche des die lichtkonvertierenden Strukturen enthaltenden Körpers beschädigt werden kann. Ein wesentlicher Vorteil der Variante in Fig. 4a ist die bessere Kühlung der Konverteranordnung, vorausgesetzt, das Substrat ist gut wärmeleitend. Eine Kombination beider Varianten ist ebenfalls denkbar.

Wenn zumindest teilweise rückseitig Licht in die Partikel-Areale der erfindungsgemäßen Konverteranordnung eingekoppelt werden kann, ist eine Beleuchtung "von unten", also rückseitig relativ zur Abstrahlungsrichtung, möglich.

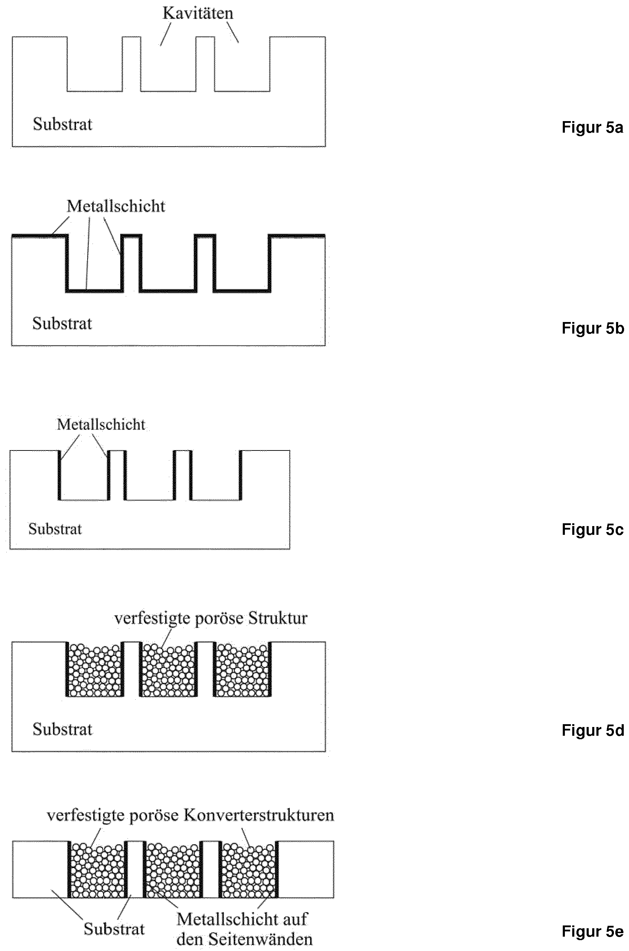

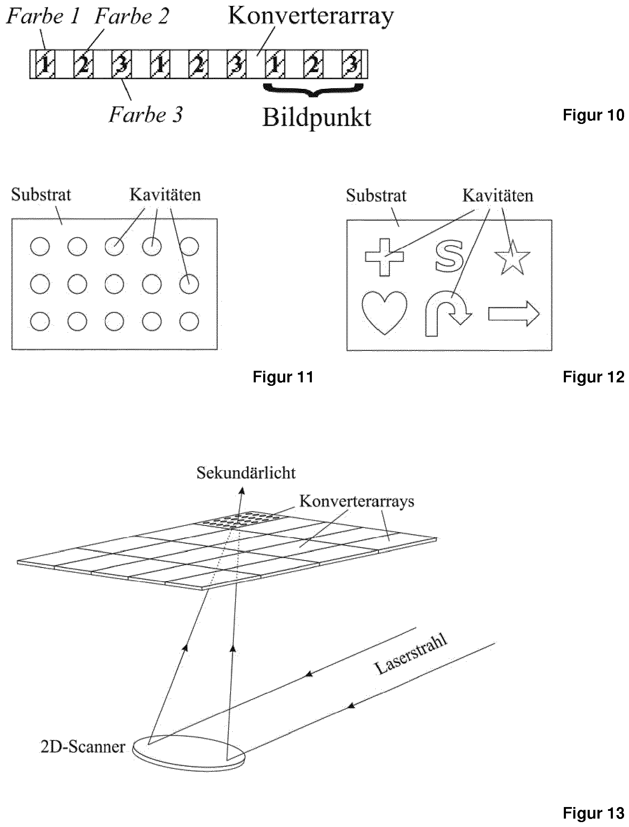

In einer weiteren, mit allen zuvor dargestellten Ausgestaltungen der Erfindung kombinierbaren Ausführungsform können die Seitenwände, gegebenenfalls auch der Boden der im Substrat erzeugten Kavitäten mit einer reflektierenden Metallschicht versehen werden, um die Lichtausbeute zu verbessern. Hierfür kann vor dem Einbringen der lichtkonvertierenden Partikel z. B. ein Metall, z. B. Aluminium oder Silber, aufgesputtert oder aufgedampft werden. Dabei wird die Kavität vollständig ausgekleidet. Bei Bedarf kann die so erzeugte Metallschicht durch einen anschließenden ganzflächigen isotropen Trockenätzprozess auf allen lateralen Flächen, d. h. vom Boden der Kavität und der Substratoberfläche, wieder entfernt werden. Dies kann günstig sein, wenn anschließend die Rückseite des Substrats entfernt wird, um ein Einkoppeln des Primärlichts von der Unterseite zu ermöglichen, wie oben beschrieben. Diese Ausgestaltung lässt sich bei verschiedenen Trägermaterialien realisieren; sie ist besonders günstig, wenn als Trägermaterial Silizium verwendet wird. In **Figur 5 a-e** sind die einzelnen Schritte gezeigt, mit denen sich eine derartige erfindungsgemäße Konverteranordnung erzeugen lässt, die eine rückseitige Einstrahlung des Primärlichts ermöglicht. Es sollte jedoch klar sein, dass die Schritte (c) und (e) weggelassen werden können, wobei eine Konverteranordnung entsteht, die der in (d) gezeigten Anordnung ähnlich ist, bei der jedoch der Boden des Substrats weiter mit einer metallischen Spiegelschicht bedeckt ist, um die Reflexion des von der Vorderseite eingestrahlten Primärlichts (siehe Fig. 10a) zu verbessern. Im Einzelnen zeigen die Abschnitte der Figur 5: das Erzeugen einer Kavität bzw. eines Arrays von Kavitäten entsprechend den Abmessungen der Konverteranordnung (Fig. 5a), das Aufbringen einer Metallschicht, die die Substratoberfläche bedeckt und die Kavitäten vollständig bzw. nahezu auskleidet (Fig. 5b), das Aufbringen einer Maskierung (z.B. einer Lackmaske) zum selektiven Ätzen von Öffnungen in der Metallschicht auf dem Boden der Kavitäten, z.B. durch einen anisotropen Trockenätzprozess (Fig. 5c), das Befüllen der Kavitäten mit losen lichtkonvertierenden Partikeln und das Verfestigen der Partikel zu festen, porösen Strukturen durch Abscheidung einer Schicht mittels CVD, insbesondere mittels Atomic Layer Deposition (Fig. 5d) und das Entfernen des Substrats unterhalb der Konverteranordnungen, um die Unterseite der Konverter (Boden der Kavität) zu exponieren (Fig. 5e).

Wird nach dem Aufbringen der Metallschicht gemäß Fig. 5b eine zusätzliche Maskierung (Lackmaske) auf das Substrat aufgebracht, kann die Metallschicht auf dem Boden der Kavität vor dem Einbringen der Phosphorpartikel strukturiert werden, ohne dass das Metall ganzflächig auf allen lateralen Flächen entfernt werden muss. Auf diese Weise lässt sich z. B. eine Aperturblende im Metall realisieren. Dies ist in den **Figuren 5c'****-e'** gezeigt, die ausgehend von einem Substrat mit metallausgekleideten Kavitäten, wie in Fig. 5b dargestellt, den weiteren Verfahrensablauf schematisch abbilden. Im Einzelnen zeigen die Abschnitte c' bis e' der Figur 5: das Aufbringen einer Maskierung (z.B. einer Lackmaske) zum selektiven Ätzen von Öffnungen in der Metallschicht auf dem Boden der Kavität, z.B. durch einen anisotropen Trockenätzprozess (Fig. 5c'), das Befüllen der Kavität bzw. der Kavitäten mit losen lichtkonvertierenden Partikeln und das Verfestigen dieser Partikel zu festen, porösen Strukturen durch Abscheidung einer Schicht mittels CVD, vorzugsweise mittels Atomic Layer Deposition (ALD) (Fig. 5d'), und das Entfernen des Substrats unterhalb der Konverteranordnung, um die Unterseite der Konverterareale (Boden der Kavität) freizustellen (Fig. 5e').

Konverteranordnungen mit sehr kleinen, kreisförmigen Aperturblenden (Pinholes) können z. B. als Punktlichtquellen dienen. Die Aperturblenden können jedoch auch jede beliebige andere Form haben.

Aperturblenden können natürlich auch im Substratmaterial erzeugt werden. Dafür können z.B. zuerst Kavitäten in einem Substrat erzeugt, diese mit lichtkonvertierenden Partikeln befüllt und letztere wie oben beschrieben zu einer porösen Struktur verfestigt werden, wie in Figur 1a-c gezeigt. Anschließend wird das Substrat von der Unterseite her teilweise abgetragen, sodass sich die mit der porösen Struktur befüllten Areale auf einer nur noch dünnen Unterlage mit definierter Restdicke befinden. Schließlich werden von unten her Aperturblenden (Pinholes) im verbleibenden Substratmaterial geöffnet. Im Falle von Silizium bzw. Metallen kann das z. B. durch Trockenätzen mittels Lackmaske erfolgen.

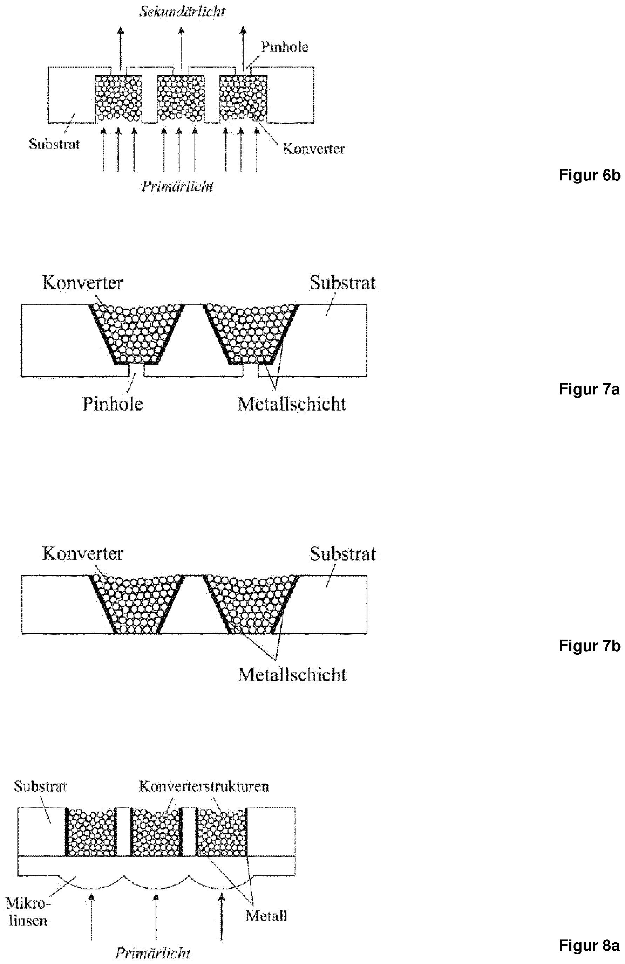

**Figur 6** fasst die zwei Möglichkeiten der Herstellung von Aperturblenden zusammen. **Fig. 6a** entspricht der umgedrehten (auf den Kopf gestellten) Struktur in Fig. 5e mit Aperturblenden in der Metallschicht, die ursprünglich auf den Boden des Substrats abgeschieden und strukturiert wurde. Hier wurde das Substrat anschließend entfernt. **Fig. 6b** zeigt eine Struktur mit Aperturblenden im Substrat. Diese Variante bietet den Vorteil einer verbesserten Kühlung der Konverteranordnung, da um die einzelnen Konverterareale herum mehr Trägermaterial stehen bleibt, weil das Substrat auf der Bodenseite der Konverterareale nicht vollständig entfernt ist. Beide Varianten können natürlich auch miteinander kombiniert werden. In diesem Fall muss allerdings nach dem Ätzen der Aperturblende im Substratmaterial gemäß Fig. 6b noch das Metall geöffnet werden, mit dem die Kavität vor dem Einbringen der lichtkonvertierenden Partikel ausgekleidet wurde (falls dies nicht schon vor dem Einbringen der Partikel erfolgte). In Abhängigkeit vom Metall stehen dazu verschiedene trocken- und nasschemische Ätzprozesse zur Verfügung.

Um die Auskopplung des Sekundärlichts zu verbessern, können die Konverterstrukturen auch geneigte Seitenflächen aufweisen, siehe **Figur 7a****-b.** Hierfür kann beim Herstellen der Kavitäten im Substrat, das häufig durch Ätzen erfolgt, die Neigung entsprechend eingestellt werden. Schritt (a) des oben im Zusammenhang mit der Figur 5 beschriebenen Verfahrens wird hierbei entsprechend modifiziert. Wird ein Silizium-Substrat eingesetzt, kann neben dem Fachmann bekannten Trockenätzprozessen auch noch das anisotrope Ätzen in wässriger KOH- oder wässriger Tetramethylammoniumhydroxid-Lösung (TMAH-Lösung) zum Einsatz kommen. Dabei entstehen rechtwinklige Kavitäten mit einem Neigungswinkel der Seitenflächen von 54°. Insbesondere das Ätzen in KOH-Lösung führt im Vergleich zum Trockenätzen zu wesentlich glatteren Seitenflächen, was deren Reflexionsverhalten verbessert. Wenn der erfindungsgemäße Konverter mit Hilfe dieses Verfahrens erzeugt wird, muss jedoch auf eine besonders enge Anordnung der Areale zueinander verzichtet werden, da die Dichte nasschemisch geätzter Konverterpixel aufgrund der geneigten Seitenflächen stets niedriger ist. Konverterareale mit geneigten Seitenflächen können in denselben Ausgestaltungen gebildet werden, wie oben für die Areale mit geraden Seitenrändern beschrieben, d.h. sie können eine reflektierende Metallauskleidung besitzen oder nicht, sie können bodenseitig für die Einstrahlung von Primärlicht geöffnet sein oder nicht, und diese Öffnung kann gegebenenfalls die Form eines "Pinholes" zur Einstrahlung von Primärlicht haben bzw. als Aperturblende ausgestaltet sein, wie voranstehend in den verschiedenen Varianten beschrieben. Figur 7a zeigt eine Ausgestaltung mit "Pinhole" und Metallisierung auf den Innenseiten der Kavität. Figur 7b zeigt eine Ausgestaltung, in der nur die Seitenflächen metallisiert sind.

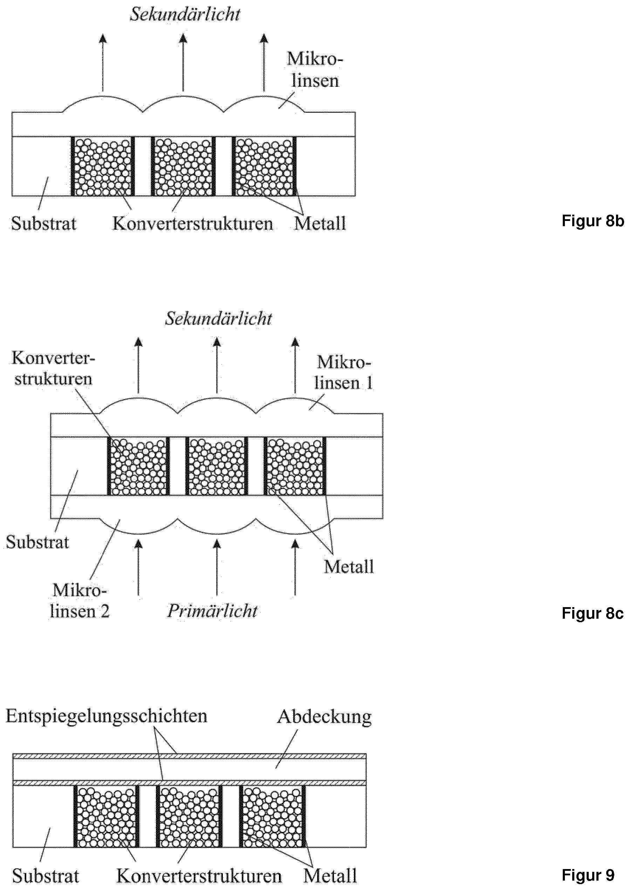

In einer spezifischen Ausgestaltung der Erfindung wird die Konverteranordnung mit einer Einrichtung zur Fokussierung oder Kollimierung z.B. mit Mikrolinsen (gewölbten Grenzflächen zum angrenzenden Medium) kombiniert, um das einfallende Primärlicht oder das austretende Sekundärlicht zu fokussieren. Drei mögliche Varianten dieser Ausgestaltung sind in **Figur 8a****-c** gezeigt. Fig. 8a zeigt eine Ausgestaltung mit Fokussierung/Kollimierung des Primärlichts durch eine einseitig aufgebrachte Linsenkonstruktion. Fig. 8b zeigt eine Konverteranordnung mit Fokussierung/Kollimierung des austretenden Sekundärlichts. Auf diese Weise können ein höherer Füllfaktor und eine Kontrast-Verschärfung erzielt werden. In Fig. 8c sind beidseitig Linsen angebracht. Diese haben laut Figur dieselbe Geometrie; selbstverständlich ist es möglich, dass die oberseitigen und die unterseitigen Linsen aus unterschiedlichen Materialien, z.B. Materialien mit unterschiedlichen Brechungsindices, bestehen und/oder unterschiedliche Formen/Geometrien besitzen. Das Aufbringen der Mikrolinsen kann dabei auf Substratebene erfolgen, wobei nur ein einziges Bauteil oder Linsensubstrat (oder eine geringere Zahl von Bauteilen oder Linsensubstraten im Vergleich zur Anzahl der Konverterareale), das in der passenden Geometrie über/unter jedem Konverterareal eine gewölbte Struktur (Linse) besitzt, mit dem Konvertersubstrat verbunden wird. Ist das Linsensubstrat aus Glas gebildet, kann die Verbindung z.B. durch anodisches Bonden erfolgen. Andere Prozesse, wie Solder-, Glasfrit- oder Adhesive-Bonden sind ebenfalls möglich. Alternativ kann das Linsensubstrat auch aus einem organischen, transparenten Material bestehen, wenn dessen Temperaturstabilität ausreichend ist, um bei nachfolgend vorgesehenen Prozessen nicht zu degradieren. Alternativ können einzelne Konverterareale oder Gruppen mit einer kleineren Anzahl von Konverterarealen mit Mikrolinsen versehen werden. So kann das Trägerelement bzw. kann das Substrat gegebenenfalls zuerst in Chips oder kleinere Konverterbereiche mit weniger Arealen vereinzelt werden, an denen dann separat entsprechende Linsen angebracht werden.

In einer weiteren Ausgestaltung der Erfindung können die Konverteranordnungen mit einer Abdeckung verbunden werden, die vorzugsweise einseitig oder beidseitig mit einer Entspiegelungsschicht versehen ist. **Figur 9** zeigt eine solche Konverteranordnung mit einer planaren, beidseitig entspiegelten Abdeckung. Die planare Abdeckung kann z.B. aus Glas oder einem anderen, im erforderlichen Spektralbereich transparenten und bevorzugt thermisch beständigen Material bestehen. In einer ersten Variante dieser Ausgestaltung ist die Abdeckung planar. Diese Variante eignet sich vor allem dann, wenn die Entspiegelung durch diese Abdeckung auf Substratebene, d.h. für eine Vielzahl von nebeneinanderliegenden Arrays, gleichzeitig und gleichartig erfolgen soll. Eine oder mehrere Entspiegelungsschichten können jedoch auch auf die gewölbten Oberflächen von zuvor aufgebrachten Mikrolinsen (siehe Fig. 8) abgeschieden werden, beispielsweise durch Sputtern, Aufdampfen, CVD (chemical vapor deposition) oder ALD (atomic layer deposition).Die Mikrolinsen in Fig. 8b können ebenfalls mit Entspiegelungsschichten versehen werden.

In einer speziellen Ausgestaltung der Erfindung, die mit allen bisher beschriebenen Ausgestaltungen und Ausführungsformen kombinierbar ist, werden unterschiedliche lichtkonvertierende Partikel eingesetzt, um Multicolor-Abbildungen zu ermöglichen. Hierfür werden in einer ersten Ausführungsform einzelne Areale des Konverters mit unterschiedlichen lichtkonvertierenden Partikeln befüllt, wobei sich in jedem Areal aber nur eine Partikelart befindet. Dabei können mehrere Areale in gewünschter Geometrie dieselbe Partikelart enthalten. Diese Areale werden zu Gruppen (Arrays) zusammengefasst, um z.B. größere Bereiche (z. B. in Form eines Pfeils, Sterns, Quadrats) zu erhalten, die identisches Licht abstrahlen. In einer alternativen Ausführungsform können Gruppen von Arealen (Konverterarrays) erzeugt werden, die im fertigen Bauelement zusammen nur einen Bildpunkt ergeben. Jedes Areal dieser Arrays enthält eine andere Art von Partikeln. Dies ist in **Figur 10** schematisch dargestellt. Zur Herstellung solcher Konverteranordnungen kann z. B. der Prozessablauf, wie er in Fig. 1 und Fig. 5 gezeigt ist, mehrfach auf einem und demselben Substrat wiederholt werden. Dies gelingt, indem bereits fertig mit einer ersten Partikelart befüllte und verfestigte Areale mit einer Maske abgedeckt werden, bevor ein zweiter, dann ggf. z.B. auch dritter und weiterer Arbeitsgang durchgeführt wird, bei dem zweite Vertiefungen in das Substrat eingebracht und dann, wie bereits gezeigt, mit einer zweiten Partikelart befüllt und verfestigt werden. Erst wenn alle vorgesehenen Kavitäten erzeugt und mit verfestigten Partikeln bestückt sind, werden die weitergehenden Schritte wie ein teilweises oder vollständiges Wegschleifen von bodenseitigem Substrat, das Erzeugen von Lochblenden u. dgl. durchgeführt.

Eingangs der Erfindungsbeschreibung wurde die Geometrie der Areale erläutert. Dort wurde ausgeführt, dass die Areale einer Konverterstruktur häufig identische Abmessungen besitzen. Auch wurden dort vor allem Areale beschrieben, deren Oberflächengeometrie relativ regelmäßig ist, d.h. die Form von Quadraten, Rechtecken, regelmäßigen Vielecken oder Kreisen oder dergleichen besitzt. Eine Aufsicht auf eine solche Konverterstruktur ist in **Figur 11** schematisch gezeigt. In alternativen Ausgestaltungen ist dies jedoch anders: Weder müssen die Areale einer Konverterstruktur immer gleich groß sein, noch müssen sie immer dieselbe und/oder eine regelmäßige Form aufweisen.

Eine solche Alternative kann beispielsweise genutzt werden, um optische Effekte auszugleichen. Dafür kann es nämlich erforderlich sein, dass die Pixelgröße variiert wird, z. B. von der Mitte zum Rand. In solchen Fällen besitzen die Areale weiterhin dieselbe Oberflächengeometrie; ihre Fläche wird jedoch von der Mitte der Konverterstruktur zum Rand hin größer oder kleiner. Alternativ (ggf. auch zusätzlich) können die Oberflächen der Areale komplexere Geometrien besitzen, z.B. die Form von Zeichen, Buchstaben, Ziffern oder Icons haben. Eine Konverterstruktur mit jeweils unterschiedlich geformten Arealen ist in **Figur 12** gezeigt. Selbst wenn das Primärlicht solch eine Konverterstruktur nur teilweise beleuchtet, wird aufgrund der Streuung in den einzelnen Arealen das Sekundärlicht gemäß deren Form abgestrahlt. Prinzipiell kann die Oberfläche der Kavitäten daher jede beliebige Form und Größe aufweisen.

In weiterführenden Ausgestaltungen der Erfindung lassen sich die oben beschriebenen Konverteranordnungen in vielen verschiedenen Vorrichtungen nutzen.

In einer ersten Variante dieser Möglichkeiten werden Konverteranordnungen mit größeren Arrays von mit lichtkonvertierenden Partikeln gefüllten Arealen eingesetzt. Beispiele hierfür sind die Nutzung in adaptiven Scheinwerfern und Beleuchtungen, Displays oder Werbetafeln. Großflächige Displays und Werbetafeln basierend auf der Remote-Phosphor-Technik werden bereits kommerziell angeboten. Ein adaptiver Remote-Phosphor-Scheinwerfer wird in der schon erwähnten Druckschrift DE 10 2013 226 650 A1 beschrieben. In derartigen Vorrichtungen können die herkömmlichen Leuchtstoffflächen durch erfindungsgemäße zweidimensionale Konverterarrays mit XY Pixeln, angebracht über entsprechenden primären Leuchtquellen, realisiert werden. **Figur 13** zeigt den prinzipiellen Aufbau eines Displays, z.B. einer Werbetafel, unter Verwendung eines erfindungsgemäßen Konverterarrays. Wie darin schematisch dargestellt, lassen sich auch große Flächen durch kachelartige Aneinanderreihung einzelner Konverterarrays erzielen. Zur Modulation des Primärlichts wird z.B. ein 2D-Scanner verwendet.

Im Falle adaptiver Scheinwerfer kann ein Konverterarray genutzt werden, bei dem entweder mit lichtkonvertierenden Partikeln gefüllte Areale in Substratvertiefungen vorhanden sind, wobei die Primärlichteinstrahlung und die Sekundärlichtabstrahlung über dieselbe Oberfläche der Konverterarrays erfolgt, wie schematisch in Figur 3a gezeigt, oder die mit lichtkonvertierenden Partikeln gefüllten Areale befinden sich in einem gitterartigen Träger ohne Boden und können dementsprechend rückseitig mit Primärlicht beleuchtet werden, wie schematisch in Figur 3b gezeigt.

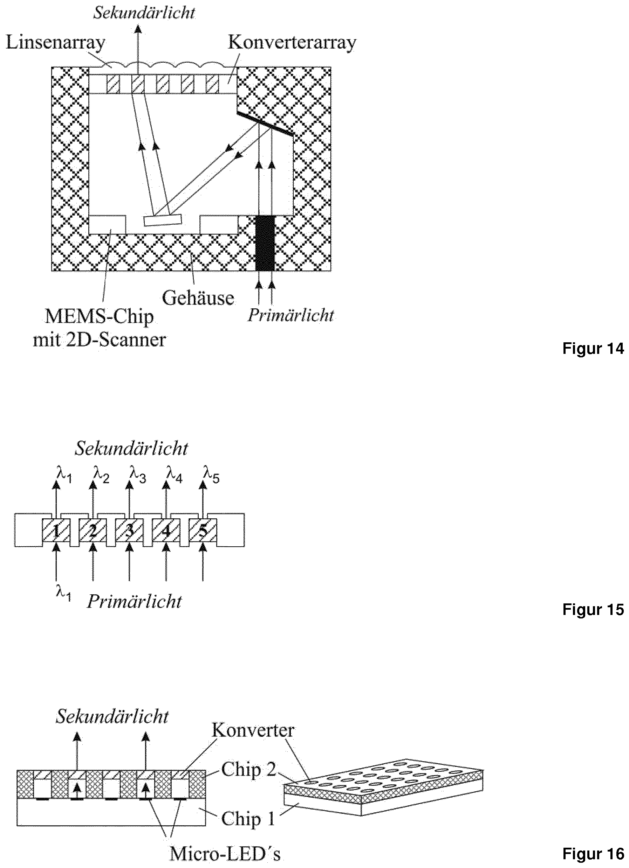

In einer zweiten Variante der Erfindung werden die erfindungsgemäßen Konverteranordnungen in miniaturisierten Bauelementen eingesetzt. Ein erstes Beispiel für diese Ausgestaltung der Erfindung sind miniaturisierte Projektoren. Da sich, wie oben ausgeführt, sehr kleine mit lichtkonvertierenden Partikeln gefüllte Areale realisieren lassen, können diese als sehr kleine, optisch voneinander isolierte Pixel eingesetzt werden. So kann ein 2D-Konverterarray mit einem 2D-MEMS-Scanner kombiniert und auf kleinstem Raum in einem Gehäuse zusammengefasst werden. Ein Beispiel hierfür ist in **Figur 14** gezeigt, in der der prinzipielle Aufbau eines miniaturisierten Projektors unter Verwendung eines erfindungsgemäßen Konverterarrays und eines MEMS-Scanners wiedergegeben ist. Der Projektor umfasst ein Gehäuse, das auf einer Seite eine durchgehende Ausnehmung zur Einkopplung eines Primärlichts aufweist. Innerhalb des Gehäuses wird das Primärlicht über eine Spiegelfläche auf einen beweglichen Spiegel gelenkt, dessen Neigung bzw. Auslenkung z.B. piezoelektrisch oder über Elektroden elektrostatisch eingestellt werden kann. Von diesem Spiegel wird das Licht zu einer weiteren Ausnehmung im Gehäuse geführt, die mit einer erfindungsgemäßen Konverteranordnung verschlossen ist. Durch die einzelnen Areale der Konverteranordnung kann Licht vom beweglichen Spiegel hindurchtreten, wobei es in Sekundärlicht umgewandelt wird. Zur Fokussierung ist es weiterhin möglich, über den Arealen ein Linsenarray anzuordnen, derart, dass das aus jedem der Areale austretende Licht in geeigneter Weise gebündelt oder auf andere Weise wie erforderlich gelenkt wird. Alternativ kann ein derartiges Linsenarray auch auf der Rückseite der Konverterstruktur, also im Innern des miniaturisierten Projektors angeordnet sein, wie es schematisch in Fig. 15a gezeigt ist. Dabei kann jede einzelne Konverterstruktur eine eigene Linse erhalten, es können jedoch auch mehrere Konverterstrukturen von einer Linse überdeckt werden, z. B. wenn das Array aus Bildpunkten besteht, die jeder für sich mehrere Farben zusammenfassen. Eine Entspiegelung wie grundsätzlich in Fig. 16 gezeigt kann alternativ oder zusätzlich integriert sein. Um eine ggf. erforderliche Kühlung zu optimieren, sollte das Gehäuse des Projektors gut wärmeleitend sein. Auch kann es günstig sein, die seitlichen Rahmenstrukturen der lichtkonvertierenden Areale möglichst voluminös zu halten, was sich beispielsweise mit Maßnahmen erreichen lässt, wie sie im Zusammenhang der Erläuterungen zu Fig. 4a und 4b gezeigt sind. Zusätzlich können die Rahmenstrukturen des Konverterarrays auf beiden Seiten mit einer besonders gut leitfähigen Beschichtung versehen werden. Zudem kann das Gehäuse so ausgestaltet werden, dass die im Konverterarray entstehende Wärme gut über dessen Einspannung abgeführt wird.

Weitere Anwendungsgebiete sind Mikroskopie und Spektrometrie.

Für erstere sind einzelne, punktförmige Lichtquellen, z.B. hergestellt gemäß Fig. 7 unter Verwendung einer Aperturblende, von Interesse. Ein Scanner ist zum Einbringen des Primärlichts nicht erforderlich, das kann z. B. über eine Glasfaser oder einen anderen geeigneten Wellenleiter erfolgen. Die Punktlichtquelle kann auch direkt über bzw. vor der Primärlichtquelle montiert werden.

Arrays aus einzeln selektierbaren Punktlichtquellen, deren Sekundärlicht jeweils in einem anderen möglichst schmalbandigen Bereich des Spektrums liegt, können in Spektrometern eingesetzt werden. Bisher hat man die Wellenlänge in derartigen Vorrichtungen mittels Blenden oder Filtern selektiert. Das ist mit erheblichen Intensitätsverlusten verbunden, da dadurch der überwiegende Anteil der Primärlichtintensität ausgeblendet bzw. absorbiert wird. Zudem ist eine Mechanik zur Positionierung der Blende bzw. Selektion der Filter erforderlich. Mit der in **Figur 15** schematisch dargestellten Konverteranordnung, die sich z.B. in ein miniaturisiertes System, wie in Fig. 14 gezeigt, eingebunden werden kann, lässt sich beides verbessern. Fig. 15 zeigt ein Array von Punktlichtquellen, deren Sekundärlicht in unterschiedlichen Spektralbereichen liegt. λ₁- λ₅ entspricht der Wellenlänge im Zentrum des jeweiligen Spektralbereiches. Soweit das Primärlicht durch das lichtkonvertierende Material nicht vollständig konvertiert wird, kann es bei der in Fig. 15 gezeigten Anordnung z.B. durch eine planare Abdeckung herausgefiltert werden. Eine solche Abdeckung kann wie die in Fig. 9 gezeigte Abdeckung gestaltet sein. Dabei kann die Abdeckung selbst als Filter agieren bzw. eine Filterschicht tragen.

Ein System wie in Fig. 14 dargestellt kann auch als adaptives Blitzlicht dienen. Dauer und Intensität des Blitzlichts werden schon heute bei einer fotografischen Aufnahme an die Lichtverhältnisse angepasst. Von Interesse wäre es daher sicherlich auch, die Ausleuchtung individuell einzustellen. In einer Ausgestaltung kann die gewünschte Ausleuchtung durch eine synchron zur Auslenkung des Scanners gesteuerte Intensitätsmodulation des Primärlichts erreicht werden. In einer weiteren Ausgestaltung kann die gewünschte Ausleuchtung durch eine gezielte periodische Modulation der Auslenkung des Scanners erreicht werden. Beide Verfahren können auch kombiniert werden. Bei einer ausreichend hohen Scangeschwindigkeit des Scanners sowie Lichtleistung des Sekundärlichts kann auf diese Weise eine zu fotografierende Szene in Bruchteilen einer Sekunde für eine Aufnahme ausgeleuchtet werden.

In weiteren Varianten von in miniaturisierten optoelektronischen Bauelementen eingesetzten erfindungsgemäßen Konverteranordnungen werden diese mit Mikro-LED-Arrays anstelle von 1D- oder 2D-Scannern kombiniert. Von Vorteil ist, dass solche Systeme ohne bewegliche Teile auskommen, weder Lichtquelle noch eine aufwendige Optik benötigen und sich noch weiter miniaturisieren lassen. Mikro-LED-Arrays sind von hohem Interesse für die optische Kommunikation, miniaturisierte Displays z. B. für Datenbrillen oder "wearable computers" oder die maskenfreie Photolithogaphie. J. J. D. McKendry et. al. haben in "Visible-light communications using a CMOS-controlled micro-light-emitting-diode array", J. Lightwave Technol., Vol. 30, No. 1, 2012, ein Array aus 10x10 LEDs mit einem Wiederholabstand (Stepmaß) von 100 µm und einem Pixeldurchmesser von 45 µm in einer InGaN-Epitaxieschicht auf einem Silizumsubstrat erzeugt. Von W. C. Chong et. al., "1700 pixels per inch (PPI) passivematrix micro-LED display powered by ASIC", Proc. CSICs, La Jolla, CA, 2014, wird ein LED-Array mit 256x192 nur 15x15 µm² großen, getrennt ansteuerbaren Pixeln beschrieben, das durch Flip-Chip-Bonden mit einem Treiberchip integriert wurde. Diese miniaturisierten LEDs innerhalb eines Arrays emittieren jedoch alle in einer Farbe, die durch das verwendete Halbleitermaterial vorgegeben ist. Zur Herstellung farbiger (RGB) Mikrodisplays sind daher Konverter erforderlich. Mittels bekannter Techniken lassen sich Pixelabmessungen von wenigen 10 µm jedoch nicht realisieren. Mit erfindungsgemäßen Konvertern gelingt dies hingegen. **Figur 16** zeigt eine schematische 3D-Ansicht und einen Querschnitt durch ein farbiges Mikrodisplay, bestehend aus einem Chip 1 mit Mikro-LED-Array und einem darüber aufgebrachten Chip 2 mit Konverterstrukturen, die als Array von eng beieinanderliegenden lichtkonvertierenden Arealen ausgebildet und in Größe, Form und Stepmaßen an das Mikro-LED-Array angepasst sind. Die Verbindung zwischen einem solchen Chip 2 mit den Konverterstrukturen und einem Chip 1 mit einem Micro-LED-Array kann auf Chip- oder Substratebene (Waferebene) unter Verwendung bekannter Techniken, wie z. B. Kleben oder Bonden, erfolgen.

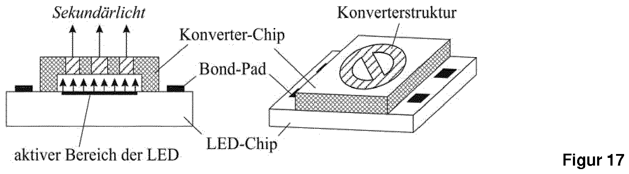

Anstelle von Arrays können auch einzelne LEDs, herkömmliche Bauteile oder Mikro-LEDs mit Konverteranordnungen kombiniert werden, wobei deren Einzelstrukturen im Gegensatz zum in Fig. 16 gezeigten System vorzugsweise stets alle gleichzeitig leuchten sollen, um z. B. kurze Phrasen, Zahlenfolgen oder Icons abbilden zu können. **Figur 17** zeigt in schematischer 3D-Ansicht und im Querschnitt ein Ausführungsbeispiel auf der Basis eines herkömmlichen LED-Chips, der durch Drahtbonden kontaktiert werden kann. Hierbei handelt es sich um ein Bauelement, bestehend aus einem Basis-Chip mit einer LED-Leuchtfläche sowie einer als Deckelchip ausgebildeten erfindungsgemäßen Konverterstruktur.

## Patentansprüche

1. Konverteranordnung zur Umwandlung eines Primärlichts in ein Sekundärlicht, umfassend mindestens einen Körper, der seitlich von einem Rahmen gehalten wird und eine lichtkonvertierende offenporige Struktur aufweist, deren Poren gasgefüllt oder evakuiert oder zumindest teilweise mit einem organischen Material, das sich von dem Material der lichtkonvertierenden Struktur unterscheidet, gefüllt sind, wobei die Oberflächen sowohl der lichtkonvertierenden Struktur als auch der Innenseiten des Rahmens mit einer transparenten Schicht frei von organischen Bestandteilen mit Hilfe eines chemischen Dampfabscheidungsverfahrens vollständig bedeckt sind, derart, dass jeder der genannten Körper ein Areal bildet, in dem eine Eigenschaft des einfallenden Lichtes und vorzugsweise dessen Wellenlänge verändert wird.

2. Konverteranordnung nach Anspruch 1, worin der mindestens eine Körper auf einem Substrat aufliegt und von diesem gestützt ist, wobei das Substrat auch die Rahmenstruktur bildet.

3. Konverteranordnung nach Anspruch 1, worin der mindestens eine Körper eine unterseitige Fläche besitzt, die der Einstrahlung von Licht zugänglich ist, und oberseitig eine Fläche besitzt, die der Abstrahlung von Licht zugänglich ist.

4. Konverteranordnung nach einem der voranstehenden Ansprüche, worin die lichtkonvertierende Struktur eines jeden Körpers aus lose eingefüllten Partikeln besteht, die durch die transparente Schicht untereinander verbunden sind.

5. Konverteranordnung nach Anspruch 4, worin die Partikel ausschließlich aus anorganischem Material bestehen.

6. Konverteranordnung nach Anspruch 4 oder 5, worin ein erster Teil der Partikel aus einem lichtkonvertierenden Material besteht und ein zweiter Teil der Partikel aus einem nicht lichtkonvertierenden, optisch transparenten Material besteht.

7. Konverteranordnung nach einem der Ansprüche 4 bis 6, worin die Partikel einen durchschnittlichen Durchmesser im Bereich von 1 bis 50 µm, vorzugsweise von 10 bis 20 µm aufweisen.

8. Konverteranordnung nach einem der voranstehenden Ansprüche, worin die transparente anorganische Schicht eine Dicke im Bereich von 5 nm bis 5 µm und vorzugsweise von 10 nm bis 300 nm oder von 10 nm bis 1 µm besitzt.

9. Konverteranordnung nach einem der Ansprüche 9 bis 15, worin die Dicke der transparenten Schicht 0,5 bis 50 % des Durchmessers der Partikel beträgt.

10. Konverteranordnung nach Anspruch 3 oder einem davon abhängigen Anspruch, weiterhin umfassend eine Fokussier- und/oder Kollimiereinrichtung, die sich unterhalb oder oberhalb oder unter- und oberhalb eines Teils der Areale oder eines jeden Areals befindet, in dem eine Eigenschaft des einfallenden Lichtes verändert wird, wobei die Fokussier- und/oder Kollimiereinrichtung aus einzelnen Linsen oder einer Linsenstruktur, die sich über die Konverteranordnung erstreckt, besteht, derart, dass sich unterhalb und/oder oberhalb eines jeden der genannten Areale ein Element der Linsenstruktur befindet, das außenseitig eine gebogene Fläche besitzt, wobei die Linsen oder die Linsenstruktur einseitig oder beidseitig eine Entspiegelungsschicht aufweisen kann/können.

11. Konverteranordnung nach einem der Ansprüche 1 bis 10, worin zwei oder mehr benachbarte Areale jeweils unterschiedliche Arten von lichtkonvertierenden Partikeln enthalten und zu einem Array zusammengefasst sind, das für die Erzeugung nur eines Bildpunktes vorgesehen ist.

12. Displayanordnung, umfassend eine oder mehrere Konverteranordnung(en) nach einem der voranstehenden Ansprüche, wobei das Display einen Spiegel oder einen 2D-Scanner oder eine Punktlichtquelle, beispielsweise einen Laser, aufweist und die Konverteranordnung(en) derart angebracht sind, dass das vom Spiegel, von dem 2D-Scanner oder von der Primärlichtquelle abgestrahlte Licht durch die Konverteranordnung geführt und darin in ein Sekundärlicht konvertiert wird.

13. Miniaturisiertes Bauelement, umfassend ein Substrat mit mindestens einer Primärlichtquelle sowie eine Konverteranordnung nach Anspruch 3, **dadurch gekennzeichnet, dass** der Rahmen der Konverteranordnung auf dem Substrat die oder jede der Primärlichtquellen umgibt, derart, dass das Licht der mindestens einen Primärlichtquelle durch einen lichtkonvertierenden Körper der Konverteranordnung geführt wird.

14. Miniaturisiertes Bauelement, umfassend ein Substrat mit mindestens einer Primärlichtquelle sowie ein die mindestens eine Primärlichtquelle beabstandet überdeckendes Gehäuse, **dadurch gekennzeichnet, dass** gegenüber der mindestens einen Primärlichtquelle eine Konverteranordnung nach Anspruch 3 in das Deckgehäuse integriert ist.

15. Verfahren zur Herstellung einer Konverteranordnung nach einem der Ansprüche 1 bis 11, umfassend die Schritte:
(a) Bereitstellen eines flächigen Substrats,
(b) Ausbilden mindestens einer Kavität in der Oberfläche des Substrats,
(c) Einfüllen von Partikeln mit lichtkonvertierenden Eigenschaften in die mindestens eine Kavität,
(d) Abscheiden einer transparenten anorganischen Schicht auf den Partikeln und den Innenseiten des Rahmens mit Hilfe eines chemischen Dampfabscheideverfahrens, vorzugsweise mit Hilfe von ALD, und
(e) optionales Entfernen des Substrats unterhalb der Konverteranordnung.

## Claims

1. A converter assembly for converting a primary light into a secondary light, comprising at least one body laterally supported by a frame and having a light-converting open-pore structure whose pores are gas-filled or evacuated or at least partially filled with an organic material different from the material of the light-converting structure, the surfaces of both the light-converting structure and the inner sides of the frame being completely covered with a transparent layer free of organic components, such that each of said bodies forms an area in which a property of the incident light and preferably its wavelength is changed.

2. The converter assembly of claim 1, wherein the at least one body rests on and is supported by a substrate, the substrate also forming the frame structure.

3. The converter assembly of claim 1, wherein the at least one body has a lower surface accessible to the irradiation of light and an upper surface accessible to the emission of light.

4. The converter assembly according to any one of the preceding claims, wherein the light-converting structure of each body consists of loosely filled particles interconnected by the transparent layer.

5. The converter assembly of claim 4, wherein the particles consist exclusively of inorganic material.

6. The converter assembly according to claim 4 or 5, wherein a first part of the particles consists of a light-converting material and a second part of the particles consists of a non-light-converting, optically transparent material.

7. The converter assembly according to any one of claims 4 to 6, wherein the particles have an average diameter in the range of from 1 to 50 µm, preferably from 10 to 20 µm.

8. The converter assembly according to any one of the preceding claims, wherein the transparent inorganic layer has a thickness in the range from 5 nm to 5 µm and preferably from 10 nm to 300 nm or from 10 nm to 1 µm.

9. The converter assembly of any one of claims 9 to 15, wherein the thickness of the transparent layer is 0.5 to 50% of the diameter of the particles.

10. The converter assembly according to claim 3 or a claim dependent thereon, further comprising a focusing and/or collimating device which is located below or above or below and above a part of the areas or each area in which a property of the incident light is changed, wherein the focusing and/or collimating device consists of individual lenses or a lens structure, which extends over the converter arrangement, in such a way that an element of the lens structure which has a curved surface on the outside is located below and/or above each of the said areas, it being possible for the lenses or the lens structure to have an antireflection layer on one side or on both sides.

11. The converter assembly according to any one of claims 1 to 10, wherein two or more adjacent areas each contain different types of light-converting particles and are combined into an array provided for generating only one pixel.

12. A display arrangement comprising one or more converter arrangement(s) according to any one of the preceding claims, wherein the display comprises a mirror or a 2D scanner or a point light source, for example a laser, and the converter arrangement(s) are mounted such that the light emitted from the mirror, 2D scanner or primary light source is passed through the converter arrangement and converted therein into a secondary light.

13. A miniaturised component comprising a substrate having at least one primary light source and a converter arrangement according to claim 3, **characterised in that** the frame of the converter arrangement on the substrate surrounds the or each primary light source such that the light from the at least one primary light source is guided through a light converting body of the converter arrangement.

14. The miniaturised component comprising a substrate having at least one primary light source and a housing covering the at least one primary light source at a distance, **characterised in that** a converter assembly according to claim 3 is integrated into the cover housing opposite the at least one primary light source.

15. A method of manufacturing a converter assembly according to any one of claims 1 to 11, comprising the steps of:
(a) providing a flat substrate,
(b) forming at least one cavity in the surface of the substrate,
(c) filling particles with light-converting properties into the at least one cavity,
(d) depositing a transparent inorganic layer on the particles and the inner sides of the frame by means of a chemical vapour deposition process, preferably by means of ALD, and
(e) optional removal of the substrate below the converter assembly.

## Revendications

1. Dispositif de convertisseur destiné à transformer une lumière primaire en une lumière secondaire, comprenant au moins un corps, qui est maintenu latéralement par un cadre et présente une structure de conversion de lumière à pores ouverts, dont les pores sont remplis de gaz ou vidés ou au moins partiellement remplis d'un matériau organique qui est différent du matériau de la structure de conversion de lumière, dans lequel les surfaces aussi bien de la structure de conversion de lumière que des côtés intérieurs du cadre sont entièrement recouvertes, à l'aide d'une méthode de dépôt chimique en phase vapeur, d'une couche transparente exempte de composants organiques de telle sorte que chacun desdits corps forme une zone dans laquelle une propriété de la lumière incidente et de préférence de sa longueur d'onde est modifiée.

2. Dispositif de convertisseur selon la revendication 1, dans lequel l'au moins un corps repose sur un substrat et est supporté par celui-ci, le substrat formant également la structure de cadre.

3. Dispositif de convertisseur selon la revendication 1, dans lequel l'au moins un corps possède une surface du côté inférieur qui est accessible à l'irradiation de lumière, et possède une surface du côté supérieur qui est accessible à l'émission de rayonnement de lumière.

4. Dispositif de convertisseur selon une des revendications précédentes, dans lequel la structure de conversion de lumière possède à chaque fois un corps composé de particules remplies en vrac qui sont liées les unes en dessous des autres par la couche transparente.

5. Dispositif de convertisseur selon la revendication 4, dans lequel les particules sont composées exclusivement de matériau anorganique.

6. Dispositif de convertisseur selon la revendication 4 ou 5, dans lequel une première partie des particules est composée d'un matériau de conversion de lumière et une seconde partie des particules est composée d'un matériau transparent optique non-convertissant la lumière.

7. Dispositif de convertisseur selon une des revendications 4 à 6, dans lequel les particules présentent un diamètre moyen compris dans la plage de 1 à 50 µm, de préférence de 10 à 20 µm.

8. Dispositif de convertisseur selon une des revendications précédentes, dans lequel la couche anorganique transparente possède une épaisseur comprise dans la plage de 5 nm à 5 µm et de préférence de 10 nm à 300 nm ou de 10 nm à 1 µm.

9. Dispositif de convertisseur selon une des revendications 9 à 15, dans lequel l'épaisseur de la couche transparente représente 0,5 à 50 % du diamètre des particules.

10. Dispositif de convertisseur selon la revendication 3 ou une revendication dépendante de celle-ci, comprenant en outre un moyen de focalisation et/ou de collimation, qui se trouve en-dessous ou au-dessus, ou bien en-dessous et au-dessus, d'une partie des zones ou de chacune des zones où une propriété de la lumière incidente est modifiée, dans lequel le moyen de focalisation et/ou de collimation est composé de lentilles individuelles ou d'une structure de lentilles qui s'étend sur le dispositif de convertisseur de telle sorte que, en-dessous et/ou au-dessus de chacune desdites zones, se trouve un élément de la structure de lentilles qui possède du côté extérieur une surface courbée, les lentilles ou la structure de lentilles pouvant présenter sur un côté ou sur les deux côtés une couche antireflet.

11. Dispositif de convertisseur selon une des revendications 1 à 10, dans lequel deux ou plusieurs zones adjacentes contiennent respectivement des types différents de particules de conversion de lumière et sont regroupées en une matrice qui est prévue pour la génération uniquement d'un point d'image.

12. Agencement d'affichage, comprenant un ou plusieurs dispositif(s) de convertisseur selon une des revendications précédentes, dans lequel l'affichage présente un miroir ou un scanneur 2D ou une source ponctuelle de lumière, par exemple un laser, et le(s) dispositif(s) de convertisseur est (sont) disposé(s) de telle sorte que la lumière rayonnée par le miroir, par le scanneur 2D ou par la source de lumière primaire est guidée à travers le dispositif de convertisseur et y est convertie en une lumière secondaire.

13. Composant miniaturisé, comprenant un substrat avec au moins une source de lumière primaire ainsi qu'un dispositif de convertisseur selon la revendication 3, **caractérisé en ce que** le cadre du dispositif de convertisseur sur le substrat entoure la source de lumière primaire ou chacune de celles-ci de telle sorte que la lumière de l'au moins une source de lumière primaire est guidée à travers un corps de conversion de lumière du dispositif de convertisseur.

14. Composant miniaturisé, comprenant un substrat avec au moins une source de lumière primaire ainsi qu'un boîtier recouvrant à distance l'au moins une source de lumière primaire, **caractérisé en ce que**, vis-à-vis de l'au moins une source de lumière primaire, est intégré dans le boîtier de recouvrement un dispositif de convertisseur selon la revendication 3.

15. Procédé destiné à fabriquer un dispositif de convertisseur selon une des revendications 1 à 11, comprenant les étapes :
(a) préparation d'un substrat de grande étendue,
(b) façonnage d'au moins une cavité dans la surface du substrat,
(c) remplissage de particules avec des propriétés de conversion de lumière dans l'au moins une cavité,
(d) séparation d'une couche anorganique transparente sur les particules et les côtés intérieurs du cadre à l'aide d'un procédé de déposition en phase vapeur, de préférence par ALD (dépôt de couches minces atomiques), et
(e) en option suppression du substrat en-dessous du dispositif de convertisseur.
